# EUROPEAN PATENT APPLICATION

(11) **EP 4 845 364 A1**
(43) Date of publication of application: **25.11.2026**
(21) Application number: 25742243.6
(22) Date of filing: 15.01.2025
(51) Int. Cl.: H10K 50/19, H10K 50/13, H10K 30/15, H10K 85/50, H10K 50/852, H10K 50/15, H10K 50/16

(54) **TANDEM LIGHT-EMITTING DEVICE AND MANUFACTURING METHOD THEREOF**

(30) Priority: 15.01.2024 KR 20240006244
(71) Applicant: Seoul National University R&DB Foundation, Seoul 08826 (KR)
(72) Inventor: LEE, Tae-Woo, Seoul 06617 (KR); KIM, Sungjin, Seoul 08815 (KR); LEE, Hyeon-Dong, Suwon-si, Gyeonggi-do 01408 (KR); WOO, Seung-Je, Seoul 06966 (KR)
(74) Representative: AWA Sweden AB
(86) International application number: PCT/KR2025/000924
(87) International publication number: WO 2025/155104

(57) **Abstract**

The present invention relates to a tandem light-emitting device and a manufacturing method thereof. The tandem light-emitting device according to the present invention and a display device comprising same have maximized color purity and luminescence efficiency, improved on-off response, outstanding operational lifetime, and low manufacturing cost. In addition, the method for manufacturing a tandem light-emitting device according to the present invention offers low production cost, and enablesfabrication of the tandem light-emitting device of the present invention.

## Description

### TECHNICAL FIELD

The present invention relates to a tandem light-emitting device and a method for manufacturing the same, and more specifically to a tandem light-emitting device having excellent color purity and luminescence efficiency and a method for manufacturing the same.

Meanwhile, it is disclosed that the present invention was invented with the support of the following national research and development projects.
[National Research and Development Project 1 that supported this invention]
[Project Identification Number] 2710016197 [Project Number] 2016R1A3B1908431 (1711181228)
[Name of Ministry] Ministry of Science and ICT [Name of Project Management (Specialized) Institution] National Research Foundation of Korea
[Title of Research Project] Individual Basic Research (Ministry of Science and Technology)
[Title of Research Task] Nanoparticle-Mimicking Polycrystalline Optoelectronic Device Leader Research
[Name of Project Performance Institution] Seoul National University [Research Period] March 1, 2024 to February 28, 2025
[National Research and Development Project 2 that supported this invention]
[Project Identification Number] 2710006449 [Project Number] 00422598 (2400422598)
[Name of Ministry] Ministry of Science and ICT
[Name of Project Management (Specialized) Institution] Science and Technology Commercialization Promotion Agency
[Title of Research Project] Industry-Academia-Research Cooperation Activation Support Project - University Technology Management Promotion
(IP Star Scientists, Support Type)
[Title of Research Task] IP Advancement and Commercialization for Commercialization of Next-Generation Electronic Materials and Electronic Devices Using the Optical and Electrical Properties of Perovskite
[Name of Project Performance Institution] Seoul National University [Research Period] April 1, 2025 to December 31, 2025

### BACKGROUND ART

The current display industry is evolving toward a lightweight and thin form with high efficiency, low power, high resolution and high color purity.

Perovskite light-emitting devices (e.g., perovskite light-emitting diodes, PeLEDs), which include only perovskite light-emitting units, have a narrow full width at half maximum (FWHM) of an emission peak in an electroluminescence (EL) spectrum, thus exhibiting high color purity, and they are also attracting attention as promising devices that can be used in next-generation display devices due to the simple synthesis and low material costs thereof. However, they have a limitation in that the electroluminescence efficiency thereof is lower than that of organic light-emitting devices (e.g., organic light-emitting diodes, OLEDs), which include only organic light-emitting units.

On the other hand, although organic light-emitting devices have higher electroluminescence efficiency than perovskite light-emitting devices, they have the disadvantage of having a large full width at half maximum (FWHM) of the emission peak of an electroluminescence spectrum, resulting in reduced color vividness, and relatively more expensive materials compared to perovskite light-emitting devices.

In order to overcome the limitations of a single light-emitting device including only a single light-emitting unit, such as the perovskite light-emitting unit or organic light-emitting unit described above, a method of applying a tandem structure including both of an organic light-emitting unit and a perovskite light-emitting unit, as disclosed in Korean Registered Patent Publication No. 10-2168612, has been proposed. When a tandem structure is used, it is theoretically expected that high luminescence efficiency can be achieved while maintaining sufficiently low color purity, and that the operating lifetime can be improved due to reduced electrical stress, compared to the case where a device is manufactured by using individual light-emitting units. However, existing tandem-structured light-emitting devices, including the invention disclosed in Korean Registered Patent Publication No. 10-2168612, simply combined an organic light-emitting unit and a perovskite light-emitting unit, and each light-emitting unit had different resistance and J-V-L characteristics. Therefore, the electroluminescence spectrum shifted overall, the full width at half maximum did not decrease, or charge imbalance occurred, and as a result, high color purity and high electroluminescence efficiency could not be guaranteed, and the operating lifetime was not sufficient.

### DISCLOSURE

### TECHNICAL PROBLEM

The present invention has been devised to solve the above-described problems, and has an object to provide a tandem light-emitting device having maximized color purity and luminescence efficiency, excellent operating lifetime and low manufacturing cost, and a display device including the same.

In addition, the present invention has another object to provide a method for manufacturing a tandem light-emitting device that is capable of manufacturing the tandem light-emitting device of the present invention at a low manufacturing cost.

The problems to be solved by the present invention are not limited to the problems mentioned above, and other problems that are not mentioned will be clearly understood by a person having ordinary skill in the technical field to which the present invention pertains from the description below.

### TECHNICAL SOLUTION

In order to solve the above-described problems, provided is a tandem light-emitting device, including: a first electrode; a perovskite light-emitting unit disposed on the first electrode, and including a first hole transport layer, a perovskite light-emitting layer and a first electron transport layer; a charge generation layer disposed on the perovskite light-emitting unit; an organic light-emitting unit disposed on the charge generation layer, and including a second hole transport layer, an organic light-emitting layer and a second electron transport layer; and a second electrode disposed on the organic light-emitting unit, wherein by controlling thicknesses of the second hole transport layer and the second electron transport layer, a full width at half maximum (FWHM) of an emission spectrum of the entire tandem light-emitting device satisfies Relationship Formula 1 below:

### <Relationship Formula 1>

FWHM (PeLED) ≤ FWHM (tandem) ≤ FWHM (OLED)
wherein the FWHM (OLED) is a full width at half maximum of a light-emitting device that includes an organic light-emitting unit and does not include a perovskite light-emitting unit, wherein the FWHM (tandem) is a full width at half maximum of the tandem light-emitting device, and wherein the FWHM (PeLED) is a full width at half maximum of a light-emitting device that includes a perovskite light-emitting unit and does not include an organic light-emitting unit.

In addition, at least one refractive index selected from the group consisting of the first hole transport layer, the first electron transport layer, the second hole transport layer, and the second electron transport layer may be in the range of 1.4 to 2.2.

In addition, the perovskite light-emitting layer may include a crystal structure of ABX₃, A₄BX₆, AB₂X₅, A₂BX₄, A₂BX₆, A₂B⁺B³⁺X₆, A₃B₂X₉ or A'₂Aₖ₋₁BₖX₃ₖ₊₁, wherein the A is a monovalent organic cation, a monovalent inorganic cation or a combination thereof, wherein the B is one or more types of metal ions, wherein the X is F⁻, Cl⁻, Br⁻, I⁻, SCN⁻, OCN⁻, SeCN⁻, HCO²⁻, CH₃COO⁻ or a combination thereof, and wherein k is an integer between 2 and 6.

In addition, the first electron transport layer and/or the second electron transport layer may have a multi-layer structure.

Additionally, in the multi-layer structure, materials included in each layer may be different from each other, wherein in the first electron transport layer, a LUMO energy level of each layer may increase as each layer gets closer to the perovskite light-emitting layer, and wherein in the second electron transport layer, a LUMO energy level of each layer may increase as each layer gets closer to the organic light-emitting layer.

In addition, the charge generation layer may include an n-type charge generation layer and/or a p-type charge generation layer.

According to an embodiment of the present invention, a thickness of the second hole transport layer and a thickness of the second electron transport layer may satisfy Relationship Formula 2 below and/or Relationship Formula 3 below:

<Relationship Formula 2> $a \leq x + by \leq c$
wherein in Relationship Formula 2, the x is a thickness of the second electron transport layer, and y is a thickness of the second hole transport layer, wherein a is - 89.474×n + 265.001, b is -1.053×n + 2.931, and c is -63.158×n + 243.001, wherein n is a refractive index of the second hole transport layer,

<Relationship Formula 3> $d \leq x + ey \leq f$
wherein in Relationship Formula 3, the x is a thickness of the second electron transport layer, and y is a thickness of the second hole transport layer, and wherein d is 15.789×m + 82.95, e is 1.105×m-0.903, and f is 135, wherein m is a refractive index of the second electron transport layer.

In addition, when Relationship Formula 2 and/or Relationship Formula 3 above are satisfied, a thickness of the second hole transport layer may be 50 to 80 nm, and a thickness of the second electron transport layer may be 40 to 60 nm.

In addition, when Relationship Formula 2 and/or Relationship Formula 3 above are satisfied, the perovskite light-emitting unit and the organic light-emitting unit may satisfy Relationship Formula 4 below:

<Relationship Formula 4> $0.8 \leq A / B \leq 1.2$
wherein the A is a current density of the perovskite light-emitting unit when an applied voltage to the perovskite light-emitting unit is 2.8 V, and wherein the B is a current density of the organic light-emitting unit when an applied voltage to the organic light-emitting unit is 2.8 V.

In addition, the organic light-emitting layer includes a host and/or a dopant, wherein the host may contain one or more selected from the group consisting of CBP, TCTA, mCP, DCzPPy, PCPPn, PCPN, CzTP, TCPB, and CzPA, and wherein the dopant may contain one or more selected from the group consisting of a fluorescent organic material, a phosphorescent organic material, and a thermally activated delayed fluorescent organic material.

In addition, the full width at half maximum of the tandem light-emitting device may be 30 nm or less.

In addition, an external quantum efficiency (EQE) of the tandem light-emitting device may be 30% or more.

In order to solve the above-described problems, provided is a display device, including the above-described tandem light-emitting device.

In order to solve the above-described problems, provided is a method for manufacturing a tandem light-emitting device, the method including: 1) forming a perovskite light-emitting unit by sequentially forming a first hole transport layer, a perovskite light-emitting layer and a first electron transport layer on a first electrode; (2) forming a charge generation layer on the first electron transport layer; (3) forming an organic light-emitting unit by sequentially forming a second hole transport layer, an organic light-emitting layer and a second electron transport layer on the charge generation layer; and (4) forming a second electrode on the second electron transport layer, wherein by controlling thicknesses of the second hole transport layer and the second electron transport layer, a full width at half maximum (FWHM) of an emission spectrum of the entire tandem light-emitting device satisfies Relationship Formula 1 below:

<Relationship Formula 1> $FWHM \left(PeLED\right) \leq FWHM \left(tandem\right) \leq FWHM \left(OLED\right)$
wherein the FWHM (OLED) is a full width at half maximum of a light-emitting device that includes an organic light-emitting unit and does not include a perovskite light-emitting unit, wherein the FWHM (tandem) is a full width at half maximum of the tandem light-emitting device, and wherein the FWHM (PeLED) is a full width at half maximum of a light-emitting device that includes a perovskite light-emitting unit and does not include an organic light-emitting unit.

In addition, the first hole transport layer and the perovskite light-emitting layer may be deposited through a solution process, and the first electron transport layer, the charge generation layer, the second hole transport layer, the organic light-emitting layer and the second electron transport layer may be deposited through a dry process.

According to an embodiment of the present invention, the second hole transport layer and the second electron transport layer may be deposited to thicknesses that satisfy Relationship Formula 2 below and/or Relationship Formula 3 below, respectively:

<Relationship Formula 2> $a \leq x + by \leq c$
wherein in Relationship Formula 2, the x is a thickness of the second electron transport layer, and y is a thickness of the second hole transport layer, wherein a is - 89.474×n + 265.001, b is -1.053×n + 2.931, and c is -63.158×n + 243.001, wherein n is a refractive index of the second hole transport layer,

<Relationship Formula 3> $d \leq x + ey \leq f$
wherein in Relationship Formula 3, the x is a thickness of the second electron transport layer, and y is a thickness of the second hole transport layer, and wherein d is 15.789×m + 82.95, e is 1.105×m-0.903, and f is 135, wherein m is a refractive index of the second electron transport layer.

In addition, when it is deposited to thicknesses that satisfy Relationship Formula 2 and/or Relationship Formula 3 above, a thickness of the second hole transport layer may be deposited to be 50 to 80 nm, and a thickness of the second electron transport layer may be deposited to be 40 to 60 nm.

In addition, the method for manufacturing a tandem light-emitting device may manufacture the above-described tandem light-emitting device.

### ADVANTAGEOUS EFFECTS

The tandem light-emitting device according to the present invention and the display device including the same have maximized color purity and luminescence efficiency, improved on-off response, excellent operating lifetime, and low manufacturing costs.

In addition, the method for manufacturing a tandem light-emitting device according to the present invention offers low production cost and enables fabrication of the tandem light-emitting device of the present invention.

It should be understood that the effects of the present invention are not limited to the effects described above, and include all effects that can be inferred from the constitutions of the invention described in the description or claims of the present invention.

### DESCRIPTION OF DRAWINGS

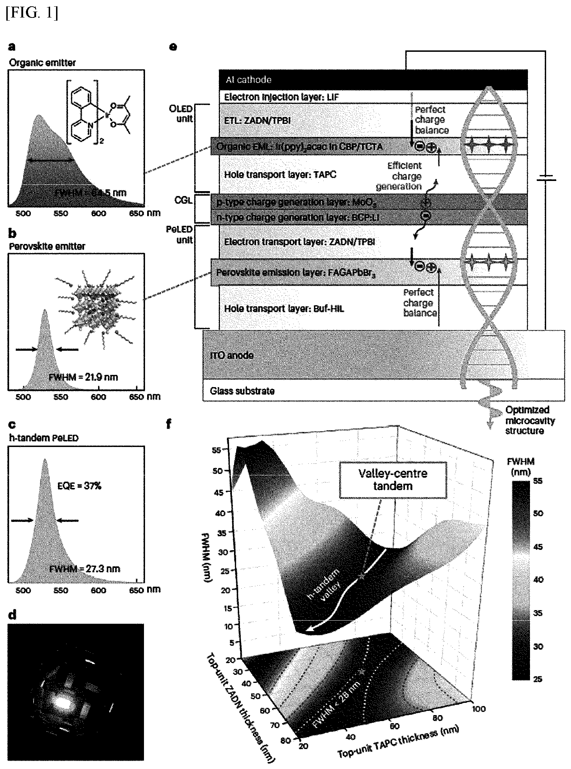

FIG. 1 is a graph showing the concept of a tandem light-emitting device of the present invention and the optical microcavity effect structure. FIG. 1a is a result of the full width at half maximum (FWHM) of an emission spectrum of a light-emitting device including only an organic light-emitting unit (hereinafter, referred to as an organic light-emitting device). FIG. 1b is a result of the full width at half maximum (FWHM) of an emission spectrum of a light-emitting device including only a perovskite light-emitting unit (hereinafter, referred to as a perovskite light-emitting device). FIG. 1c is a result of the full width at half maximum of an emission spectrum of a tandem light-emitting device according to a preferred embodiment of the present invention. FIG. 1d is a photographic image of the tandem light-emitting device of the present invention in operation. FIG. 1e is a schematic diagram of the structure of a tandem light-emitting device according to a preferred embodiment of the present invention. FIG. 1f is a three-dimensional graph deriving the results of the full width at half maximum according to the thickness of a second hole transport layer and a second electron transport layer of the organic light-emitting unit included in the tandem light-emitting device through optical simulation, which shows the optical microcavity effect.

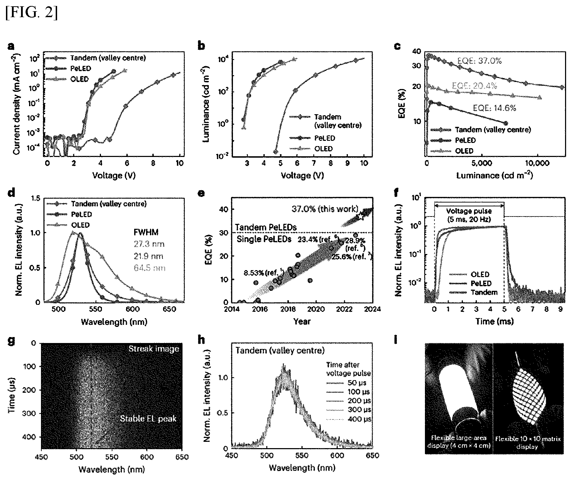

FIG. 2 shows electrical and optical measurement results for the tandem light-emitting device, perovskite light-emitting device and organic light-emitting device of the present invention. FIG. 2a shows the voltage-current density measurement results for each light-emitting device. FIG. 2b shows the voltage-luminance measurement results for each light-emitting device. FIG. 2c shows the luminance-external quantum efficiency (EQE) measurement results for each light-emitting device. FIG. 2d shows the normalized electroluminescence (EL) spectra measurement results for each light-emitting device. FIG. 2e is a graph expressing the external quantum efficiency results for the conventional perovskite light-emitting device and the tandem light-emitting device according to a preferred embodiment of the present invention. FIG. 2f shows the normalized transient EL intensity measurement results for each light-emitting device. FIG. 2g is a streak camera image captured for 500 µs during the turn-on process of the tandem light-emitting device of the present invention. FIG. 2h is a result of measuring time-resolved spectra for 500 µs during the turn-on process of the tandem light-emitting device of the present invention. FIG. 2i is a photographic image showing a large-area flexible display device including the tandem light-emitting device of the present invention.

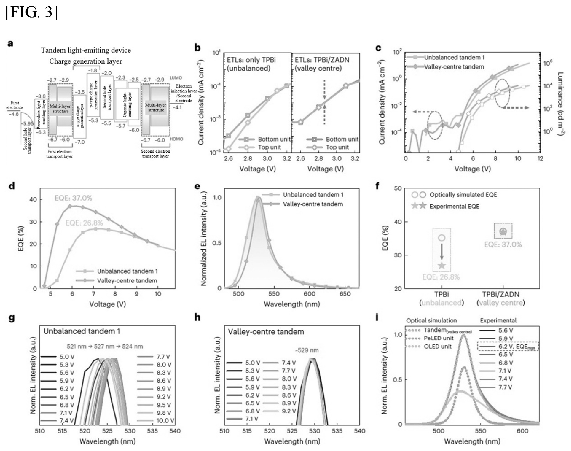

FIG. 3 shows the results of electrical optimization according to the presence or absence of a multi-layer structure in the electron transport layer included in the tandem light-emitting device. FIG. 3a shows a schematic structure of a valley-centre tandem light-emitting device (an optimized light-emitting device, a light-emitting device in which the first and second electron transport layers have a multi-layer structure). FIG. 3b shows the results of voltage-current density measurement results for each of the organic light-emitting unit and the perovskite light-emitting unit included in the valley-centre tandem light-emitting device and the unbalanced tandem light-emitting device 1 (a non-optimized light-emitting device, a tandem light-emitting device in which the first and second electron transport layers do not have a multi-layer structure). FIG. 3c shows the results of voltage-current density measurements for the valley-centre tandem light-emitting device and the unbalanced tandem light-emitting device 1. FIG. 3d shows the results of voltage-external quantum efficiency measurements for the valley-centre tandem light-emitting device and the unbalanced tandem light-emitting device 1. FIG. 3e shows the results of normalized electroluminescence spectra measurement for the valley-centre tandem light-emitting device and the unbalanced tandem light-emitting device 1. FIG. 3f shows the results of external quantum efficiency through optical simulation and actually measured external quantum efficiency for the valley-centre tandem light-emitting device and the unbalanced tandem light-emitting device 1. FIG. 3g shows the results of peak shift of the normalized electroluminescence spectrum according to the driving voltage in the unbalanced tandem light-emitting device 1. FIG. 3h shows the results of peak shift of the normalized electroluminescence spectrum according to the driving voltage in the valley-centre tandem light-emitting device. FIG. 3i shows the results of normalized electroluminescence spectra through optical simulation and actually measured normalized electroluminescence spectra for the valley-centre tandem light-emitting device, the perovskite light-emitting device and the organic light-emitting device.

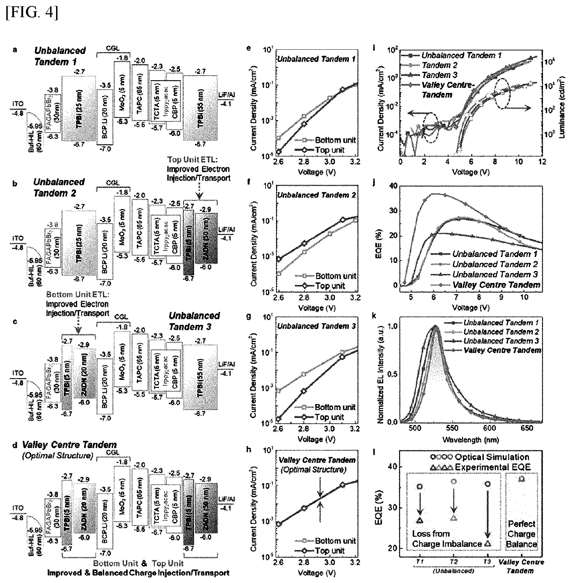

FIG. 4 shows the results of electrical optimization according to the presence or absence of a multi-layer structure in the electron transport layer included in the tandem light-emitting device. FIG. 4a and FIG. 4e show the schematic structure of an unbalanced tandem light-emitting device 1 and the results of voltage-current density measurements for each of an organic light-emitting unit and a perovskite light-emitting unit included in the unbalanced tandem light-emitting device. FIG. 4b and FIG. 4f show the schematic structure of an unbalanced tandem light-emitting device 2 and the results of voltage-current density measurements for each of an organic light-emitting unit and a perovskite light-emitting unit included in the unbalanced tandem light-emitting device. FIG. 4c and FIG. 4g show the schematic structure of an unbalanced tandem light-emitting device 3 and the results of voltage-current density measurements for each of an organic light-emitting unit and a perovskite light-emitting unit included in the unbalanced tandem light-emitting device. FIG. 4d and FIG. 4h are schematic structures of a valley-centre tandem light-emitting device and voltage-current density measurement results for each of an organic light-emitting unit and a perovskite light-emitting unit included in the tandem light-emitting device. FIG. 4i shows current density and luminance measurement results according to voltage for an unbalanced light-emitting device and a valley-centre tandem light-emitting device. FIG. 4j shows voltage and external quantum efficiency results for an unbalanced light-emitting device and a valley-centre tandem light-emitting device. FIG. 4k shows normalized electroluminescence spectrum measurement results for an unbalanced light-emitting device and a valley-centre tandem light-emitting device. FIG. 4l shows results showing external quantum efficiency through optical simulation and actually measured external quantum efficiency.

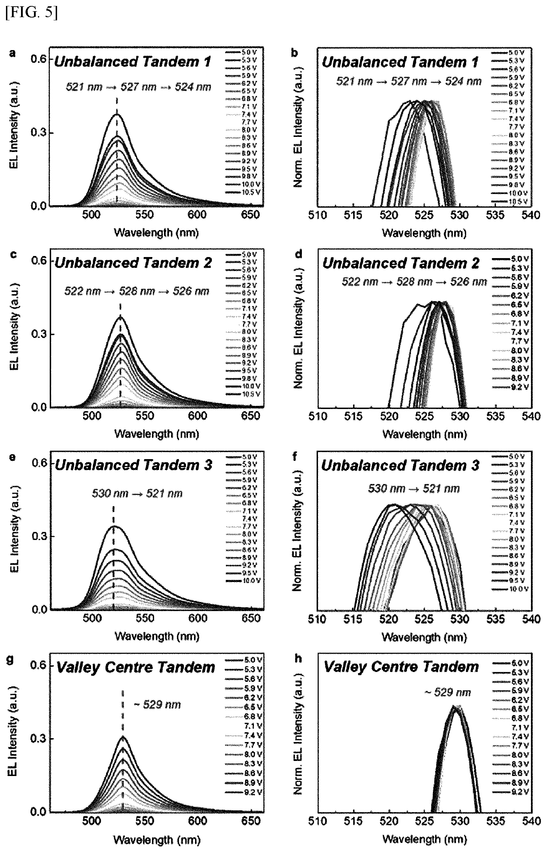

FIG. 5 shows the results of peak shifts in the electroluminescence spectrum according to driving voltage in an unbalanced light-emitting device and a valley-centre tandem light-emitting device.

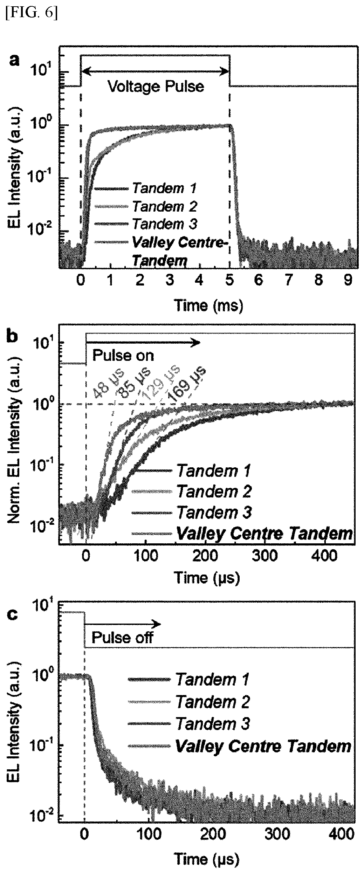

FIG. 6 shows the results of transient electroluminescence intensity measurements for an unbalanced light-emitting device and a valley-centre tandem light-emitting device. FIG. 6a shows the entire turn-on and turn-off processes, FIG. 6b is an enlarged view of the turn-on process, and FIG. 6c is an enlarged view of the turn-off process.

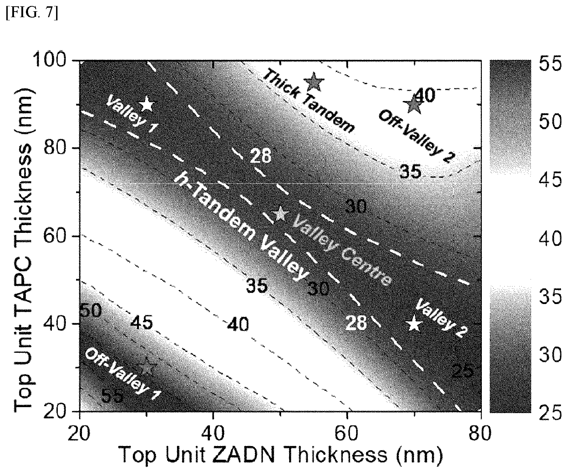

FIG. 7 is a two-dimensional graph deriving the results of the full width at half maximum according to the thicknesses of a second hole transport layer and a second electron transport layer of the organic light-emitting unit included in the tandem light-emitting device through optical simulation, and illustrates the optical microcavity effect.

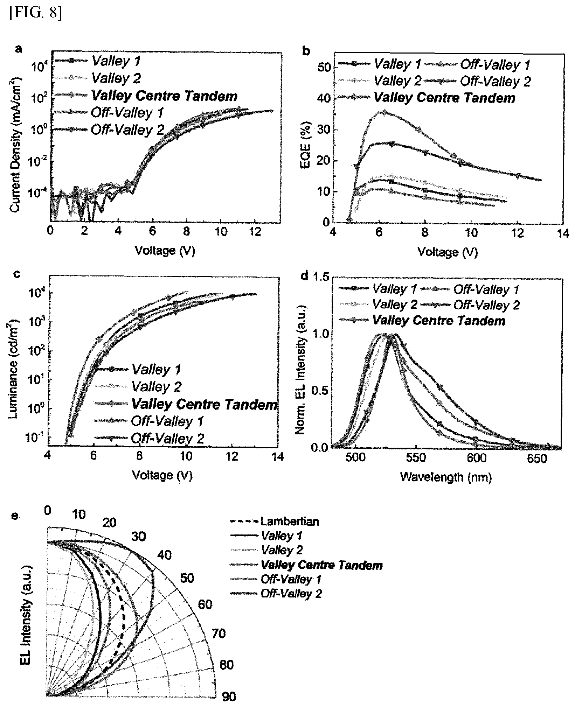

FIG. 8 shows the electrical and optical measurement results for the valley-centre tandem light-emitting devices, valley tandem light-emitting devices (valley 1 and valley 2) and off-valley tandem light-emitting devices (off-valley 1 and off-valley 2) shown in FIG. 7. FIG. 7a shows the voltage-current density measurement results of each light-emitting device. FIG. 7b shows the voltage-external quantum efficiency measurement results of each light-emitting device. FIG. 7c shows the voltage-luminance measurement results. FIG. 7d shows the normalized electroluminescence spectrum measurement results of each light-emitting device. FIG. 7e shows the electroluminescence intensity measurement results according to the angle in each light-emitting device.

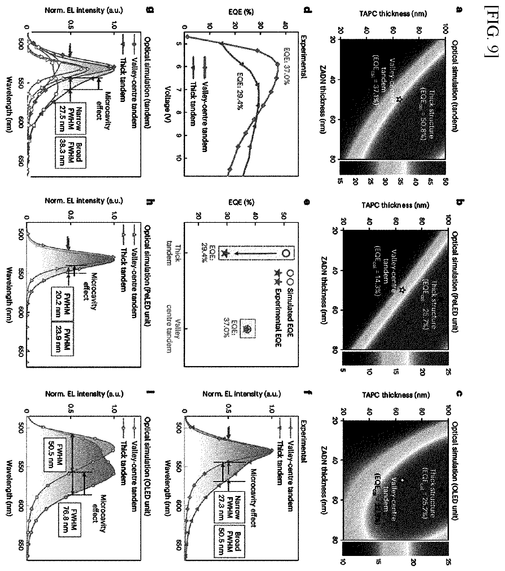

FIG. 9 shows optical simulation results and actual measurement results for a valley-centre tandem light-emitting device and a thick tandem light-emitting device. FIG. 9a shows optical simulation results for external quantum efficiency of the entire device according to the thicknesses of a second hole transport layer and a second electron transport layer of the organic light-emitting unit included in the tandem light-emitting device. FIG. 9b shows optical simulation results for external quantum efficiency of the perovskite light-emitting unit included in the tandem light-emitting device according to the thicknesses of a second hole transport layer and a second electron transport layer of the organic light-emitting unit included in the tandem light-emitting device. FIG. 9c shows optical simulation results for external quantum efficiency of the organic light-emitting unit included in the tandem light-emitting device according to the thicknesses of a second hole transport layer and a second electron transport layer of the organic light-emitting unit included in the tandem light-emitting device. FIG. 9d shows the voltage-external quantum efficiency measurement results for each tandem light-emitting device. FIG. 9e shows the results of external quantum efficiency through optical simulation and actually measured external quantum efficiency for each tandem light-emitting device. FIG. 9f shows the results of normalized electroluminescence spectrum and full width at half maximum measurement for each tandem light-emitting device. FIGS. 9g to 9i show the results of normalized electroluminescence spectrum and full width at half maximum measurement for the entire light-emitting device, perovskite light-emitting unit and organic light-emitting unit in each tandem light-emitting device through optical simulation.

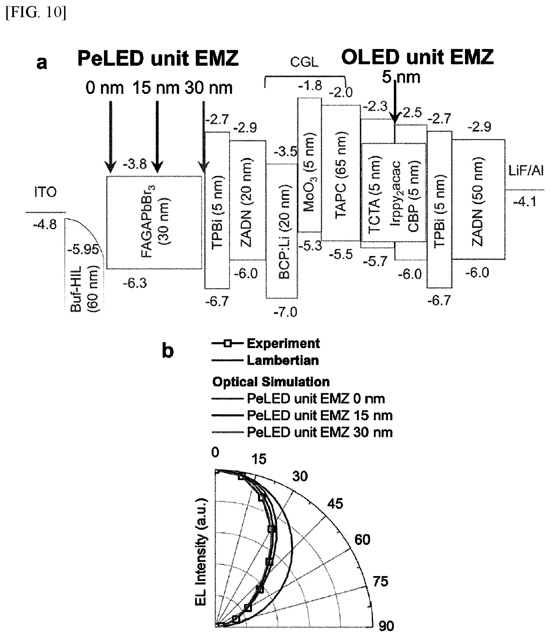

FIG. 10 shows the results of the emission zone analysis of the valley-centre tandem light-emitting device. FIG. 10a shows a schematic structure and emission zone location of the valley-centre tandem light-emitting device. FIG. 10b shows the results of an optical simulation and an actual measurement according to the emission zone location of the valley-centre tandem light-emitting device, and is an electroluminescence spectrum according to the angle.

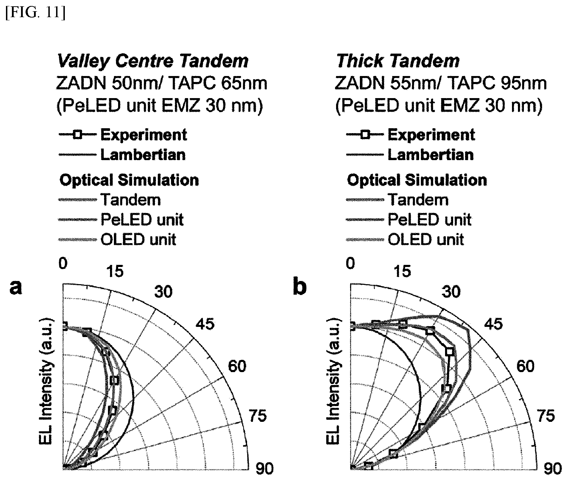

FIG. 11 shows the angle-dependent electroluminescence spectra for a valley-centre tandem light-emitting device and a thick tandem light-emitting device, and the optical simulation results and actual measurement results of the perovskite light-emitting unit and organic light-emitting unit included in each light-emitting device. FIG. 11a shows the result for a valley-centre tandem light-emitting device, and FIG. 11b shows the result for a thick tandem light-emitting device.

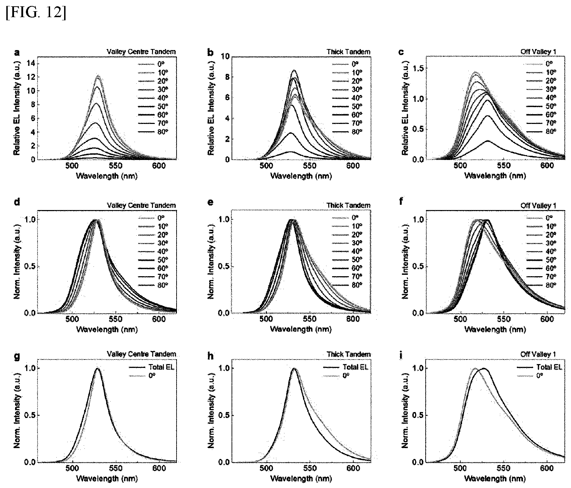

FIG. 12 shows the results of simulating the relative electroluminescence spectra according to angle, for valley-centre tandem light-emitting devices, thick tandem light-emitting devices and off-valley tandem light-emitting devices.

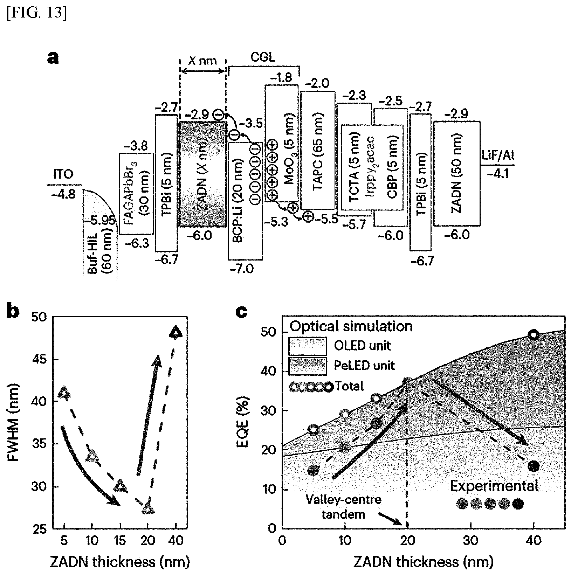

FIG. 13 shows the results of electrical and optical optimization according to the thickness of ZADN (2-[4-(9,10-Di-naphthalen-2-yl-anthracen-2-yl)-phenyl]-1-phenyl-1H-benzoimidazole) among the first electron transport layers of the perovskite light-emitting unit included in the tandem light-emitting device of the present invention. FIG. 13a shows a schematic structure of the tandem light-emitting device of the present invention and the thickness (X nm) of the ZADN. FIG. 13b shows the results showing the full width at half maximum of the electroluminescence spectrum according to the thickness of the ZADN. FIG. 13c shows the results showing the external quantum efficiency through optical simulation and the actually measured external quantum efficiency with respect to the change in the thickness of the ZADN.

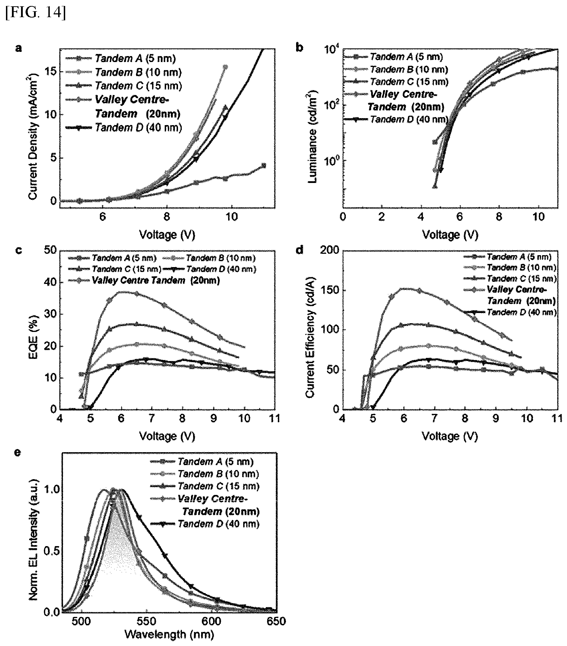

FIG. 14 shows the results of electrical and optical measurements according to the thickness of ZADN among the first electron transport layers of the perovskite light-emitting units included in the tandem light-emitting device of the present invention. FIG. 14a shows the results of voltage-current density measurements for tandem light-emitting devices with various ZADN thicknesses, FIG. 14b shows the results of voltage-luminance measurements, and FIG. 14c shows the results of voltage-external quantum efficiency measurements. In addition, FIG. 14d shows the results of voltage-current efficiency measurements, and FIG. 14e shows the results of normalized electroluminescence spectrum measurements.

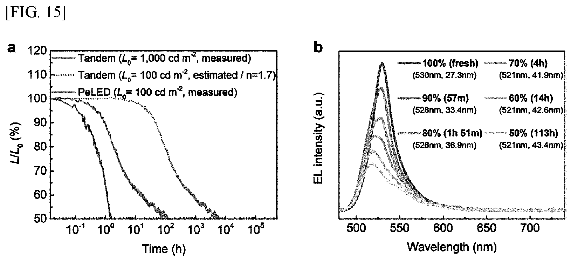

FIG. 15 shows the results of measuring the lifetime of the tandem light-emitting device and perovskite light-emitting device of the present invention. FIG. 15a shows the results of showing the change in luminance over time of each device when the initial luminance (L₀) is 1,000 cd/m², and FIG. 15b shows the results of the electroluminescence spectrum showing the luminance change and operating time at the initial luminance of the tandem light-emitting device.

### MODES OF THE INVENTION

Hereinafter, the present invention will be described in detail with reference to the attached drawings so that a person having ordinary skill in the art to which the present invention pertains can easily practice the present invention. The present invention may be implemented in various forms and is not limited to the embodiments described herein. In the drawings, parts that are not directly related to the description have been omitted in order to clearly describe the present invention.

The terminology used in the present specification is only used to describe specific embodiments and is not intended to limit the present invention. The singular expression includes the plural expression unless the context clearly indicates otherwise. In the present application, it should be understood that the terms "include" or "have" indicate that a feature, number, step, operation, component or combination thereof described in the specification is present, but do not exclude in advance the possibility that one or more other features, numbers, steps, operations, components or combinations thereof may be present or added.

Unless otherwise defined, all terms used herein, including technical or scientific terms, have the same meanings as commonly understood by one of ordinary skill in the art to which this invention pertains. Terms that are defined in commonly used dictionaries should be interpreted in meanings consistent with their meanings in the context of the relevant art, and will not be interpreted in an idealized or overly formal sense unless explicitly defined herein.

As described above, FIG. 1a shows the results of the full width at half maximum (FWHM) of an emission spectrum of a light-emitting device including only an organic light-emitting unit (hereinafter, referred to as an organic light-emitting device), and FIG. 1b shows the results of the full width at half maximum (FWHM) of an emission spectrum of a light-emitting device including only a perovskite light-emitting unit (hereinafter, referred to as a perovskite light-emitting device). As can be seen from these results, perovskite light-emitting devices (PeLEDs) have a problem of low luminescence efficiency, and organic light-emitting devices (OLEDs) have a problem of low color purity and high material costs. In order to solve this problem, there has been an attempt to manufacture a tandem light-emitting device including the two units, but conventional tandem light-emitting devices simply combine an organic light-emitting unit and a perovskite light-emitting unit, and each light-emitting unit has different resistance and J-V-L characteristics. Therefore, the light-emitting spectrum does not shift overall, the full width at half maximum does not decrease, or a charge imbalance occurs, and thus, that high color purity and high luminescence efficiency cannot be guaranteed, and the operating lifetime is not sufficient.

Accordingly, the present invention seeks to solve the above-described problems by providing a tandem light-emitting device, including: a first electrode; a perovskite light-emitting unit disposed on the first electrode, and including a first hole transport layer, a perovskite light-emitting layer and a first electron transport layer; a charge generation layer disposed on the perovskite light-emitting unit; an organic light-emitting unit disposed on the charge generation layer, and including a second hole transport layer, an organic light-emitting layer and a second electron transport layer; and a second electrode disposed on the organic light-emitting unit, wherein by controlling thicknesses of the second hole transport layer and the second electron transport layer, a full width at half maximum (FWHM) of an emission spectrum of the entire tandem light-emitting device satisfies Relationship Formula 1 below:

<Relationship Formula 1> $FWHM \left(PeLED\right) \leq FWHM \left(tandem\right) \leq FWHM \left(OLED\right)$
wherein the FWHM (OLED) is a full width at half maximum of a light-emitting device that includes an organic light-emitting unit and does not include a perovskite light-emitting unit, wherein the FWHM (tandem) is a full width at half maximum of the tandem light-emitting device, and wherein the FWHM (PeLED) is a full width at half maximum of a light-emitting device that includes a perovskite light-emitting unit and does not include an organic light-emitting unit.

Through this, the color purity as well as the luminescence efficiency such as external quantum efficiency may be maximized while increasing the operating lifetime, and high efficiency may be achieved with only two units, thereby reducing the manufacturing cost, as shown in FIGS. 1c and 1d. In this case, FIG. 1c is a result of full width at half maximum of the emission spectrum of a tandem light-emitting device according to a preferred embodiment of the present invention, and FIG. 1d is a photographic image of the tandem light-emitting device of the present invention in operation.

FIG. 1e is a schematic diagram of the structure of a tandem light-emitting device according to a preferred embodiment of the present invention, which will be described below with reference to FIG. 1e.

First of all, the first electrode and the second electrode included in the tandem light-emitting device of the present invention will be described.

The first electrode may be an anode or a cathode, and the second electrode may also be an anode or a cathode. The second electrode may be a counter electrode to the first electrode, and specifically, when the first electrode is an anode, the second electrode may be a cathode, and when the first electrode is a cathode, the second electrode may be an anode.

The first electrode or the second electrode may be any type commonly used in the art, and is not particularly limited thereto. For example, the first electrode or the second electrode may be a reflective electrode, a semi-transmissive electrode or a transmissive electrode. Preferably, the first electrode and/or the second electrode may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), indium tin oxide (ITO), indium zinc oxide (IZO), tin oxide (SnO₂), zinc oxide (ZnO), carbon nanotubes, graphene, nanowires, polymers or any combination thereof. If the first electrode is a reflective electrode, the second electrode, which is the opposite electrode, may be a semi-transmissive electrode or a transmissive electrode, but is not limited thereto.

The first electrode or the second electrode may be formed through a method commonly used in the art, and the present invention does not particularly limit the same. For example, it may be formed through a dry process and a solution (wet) process, and the dry process may be any general dry process used in the art, such as a thermal evaporation process, a vacuum deposition process, an atomic layer deposition (ALD) process, a chemical vapor deposition (CVD) process, a physical vapor deposition (PVD) process, an air jet process and the like, and the solution process may be any general solution process used in the art, such as a spin coating process, a slot die coating process, a blade coating process, a printing coating process, a gravure coating process, a spray coating process and the like.

The first electrode or the second electrode may have a single-layer structure or a multi-layer structure. In this case, a multi-layer structure means that the materials, crystals or physical properties included in each layer are different and the number of layers is two or more. Hereinafter, the meaning of a multi-layer structure is the same.

The thickness of each of the first electrode or the second electrode is not limited as long as it can be applied to a light-emitting device, and thus, the present invention does not limit the same. Preferably, it may be 50 to 200 nm. For example, each thickness may be 50, 51, 52, 53, 54, 55, 56, 57, 58, 59, 60, 61, 62, 63, 64, 65, 66, 67, 68, 69, 70, 71, 72, 73, 74, 75, 76, 77, 78, 79, 80, 81, 82, 83, 84, 85, 86, 87, 88, 89, 90, 91, 92, 93, 94, 95, 96, 97, 98, 99, 100, 102, 104, 106, 108, 110, 112, 114, 116, 118, 120, 122, 124, 126, 128, 130, 132, 134, 136, 138, 140, 142, 144, 146, 148, 150, 152, 154, 156, 158, 160, 162, 164, 166, 168, 170, 172, 174, 176, 178, 180, 182, 184, 186, 188, 190, 192, 194, 196, 198 or 200 nm.

Next, the perovskite light-emitting unit included in the tandem light-emitting device according to the present invention will be described. The perovskite light-emitting unit is disposed on the first electrode, and includes a first hole transport layer, a perovskite light-emitting layer and a first electron transport layer. Here, the meaning of the term "disposed on" does not mean that any configuration is excluded between the first electrode and the perovskite light-emitting unit, and hereinafter, the term "disposed on" has the same meaning.

The refractive index of the first hole transport layer may be, but is not limited to, in the range of 1.4 to 2.2. For example, the refractive index of the first hole transport layer at 531 nm may be 1.40, 1.41, 1.42, 1.43, 1.44, 1.45, 1.46, 1.47, 1.48, 1.49, 1.50, 1.51, 1.52, 1.53, 1.54, 1.55, 1.56, 1.57, 1.58, 1.59, 1.60, 1.61, 1.62, 1.63, 1.64, 1.65, 1.66, 1.67, 1.68, 1.69, 1.70, 1.71, 1.72, 1.73, 1.74, 1.75, 1.76, 1.77, 1.78, 1.79, 1.80, 1.81, 1.82, 1.83, 1.84, 1.85, 1.86, 1.87, 1.88, 1.89, 1.90, 1.91, 1.92, 1.93, 1.94, 1.95, 1.96, 1.97, 1.98, 1.99, 2.00, 2.01, 2.02, 2.03, 2.04, 2.05, 2.06, 2.07, 2.08, 2.09, 2.10, 2.11, 2.12, 2.13, 2.14, 2.15, 2.16, 2.17, 2.18, 2.19 or 2.20. If the refractive index of the first hole transport layer is out of the above range, the optimal optical microcavity effect may not be achieved such that the luminescence efficiency of the device decreases and the full width at half maximum of the luminescence spectrum widens, which may reduce the color purity.

Preferably, the refractive index of the first hole transport layer may be in the range of 1.4 to 1.8, and more preferably, the refractive index of the first hole transport layer may be in the range of 1.45 to 1.75. For example, the refractive index of Buf-HIL that may be used in the first hole transport layer is 1.49.

In addition, the first hole transport layer may be applied without limitation to any material commonly used in the art, but preferably, it may be a material satisfying the above-described refractive index. For example, the first hole transport layer may include at least one selected from the group consisting of a compound including an aryl group and/or a heteroaryl group, a polymer of the compound and a derivative thereof, and specifically, it may include one or more selected from the group consisting of 4,4'-cyclohexylidenebis[N,N-bis(4-methylphenyl)benzenamine] (TAPC), 4,4',4"-tris(carbazol-9-yl)triphenylamine (TCTA), N,N'-Di(1-naphthyl)-N,N'-diphenyl-(1,1'-biphenyl)-4,4'-diamine (NPB), 4,4'-bis(9-carbazolyl)-1,1'-biphenyl (CBP), poly[N,N'-bis(4-butylphenyl)-N,N'-bisphenylbenzidine] (Poly-TPD), polyaniline (PANI), Pply(n-vinylcarbazole)(PVK), poly[bis(4-phenyl)(2,4,6-trimethylphenyl)amine (PTAA) and Buf-HIL.

The first hole transport layer may have a single-layer structure or a multi-layer structure, and the present invention does not particularly limit the same.

In addition, the first hole transport layer may be a hole injection layer.

The thickness of the first hole transport layer is not particularly limited, but may preferably be 20 to 100 nm. Specifically, it may be 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59, 60, 61, 62, 63, 64, 65, 66, 67, 68, 69, 70, 71, 72, 73, 74, 75, 76, 77, 78, 79, It can be 80, 81, 82, 83, 84, 85, 86, 87, 88, 89, 90, 91, 92, 93, 94, 95, 96, 97, 98, 99 or 100 nm.

The perovskite light-emitting layer may include a crystal structure of ABX₃, A₄BX₆, AB₂X₅, A₂BX₄, A₂BX₆, A₂B⁺B³⁺X₆, A₃B₂X₉ or A'₂Aₖ₋₁BₖX₃ₖ₊₁, wherein A may be a monovalent organic cation, a monovalent inorganic cation or a combination thereof, B may be one or more types of metal ions, the X may be F⁻, Cl⁻, Br⁻, I⁻, SCN⁻, OCN⁻, SeCN⁻, HCO²⁻, CH₃COO⁻ or a combination thereof, and k may be an integer from 2 to 6. For example, A may be an amidinium group organic cation such as formamidinium (NH₂CH=NH⁺) ion, acetamidinium (NH₂C(CH)=NH₂⁺) ion or guamidinium (NHC(NH)=NH⁺) ion; or an organic ammonium (RNH₃) cation, and for example, CH₃NH₃⁺, HC(NH₂)₂⁺, C₄H₉NH₃⁺, (CH₃NH₃)ₙ, ((CₓH₂ₓ₊₁)ₙNH₃)₂(CH₃NH₃)ₙ, (RNH₃)₂, (CₙH₂ₙ₊₁NH₃)₂, (CF₃NH₃), (CF₃NH₃)ₙ, ((CₓF₂ₓ₊₁)ₙNH₃)₂(CF₃NH₃)ₙ, ((CₓF₂ₓ₊₁)ₙNH₃)₂ or (CₙF₂ₙ₊₁NH₃)₂ (wherein n is an integer greater than or equal to 1), or an organic phosphonium (RPH₃) cation or a monovalent alkali metal cation (e.g., Cs⁺).

Preferably, the perovskite light-emitting layer may include a crystal structure of ABX₃, wherein A may be a monovalent organic cation or a combination thereof, B may be one or more types of metal ions, and F may be F⁻, Cl⁻, Br⁻, I⁻ or a combination thereof.

More preferably, the perovskite light-emitting layer may include a crystal structure of APbBr₃, and A may be FA (formamidinium), GA (guanidinium) or a combination thereof.

The perovskite light-emitting layer may have a single-layer structure or a multi-layer structure, and the present invention does not particularly limit the same.

In tandem light-emitting devices, it is desirable for the perovskite light-emitting layer to have high transmittance, and for this purpose, it is desirable for it to be thin.

The thickness of the perovskite light-emitting layer may be 1 to 100 nm, but is not particularly limited. For example, it may be 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 32, 34, 36, 38, 40, 42, 44, 46, 48, 50, 52, 54, 56, 58, 60, 65, 70, 75, 80, 85, 90, 95 or 100 nm. Preferably, it may be 50 nm or less, and more preferably, it may be 30 nm or less.

If it is more than 100 nm, the transmittance of the perovskite unit decreases, thereby absorbing the light emission of the organic light-emitting unit, which may hinder the formation of an optimal cavity structure, and thus, the luminescence efficiency or color purity of the device may be lowered.

For perovskite materials, polycrystalline perovskite, quasi-2D perovskite and perovskite nanocrystal may be used.

In order to implement a high-efficiency tandem light-emitting device, it is preferable to use perovskite nanocrystals and quasi-2d perovskites, which can easily control the thickness of the perovskite light-emitting layer while reducing the transmittance, and it may be more preferable to use perovskite nanocrystals. Meanwhile, it is not impossible to use polycrystalline perovskites, and if the thickness can be controlled to less than 100 nm, this may also be used.

The refractive index of the first electron transport layer may be, but is not limited to, in the range of 1.4 to 2.2. For example, the refractive index of the first electron transport layer at 531 nm may be 1.40, 1.41, 1.42, 1.43, 1.44, 1.45, 1.46, 1.47, 1.48, 1.49, 1.50, 1.51, 1.52, 1.53, 1.54, 1.55, 1.56, 1.57, 1.58, 1.59, 1.60, 1.61, 1.62, 1.63, 1.64, 1.65, 1.66, 1.67, 1.68, 1.69, 1.70, 1.71, 1.72, 1.73, 1.74, 1.75, 1.76, 1.77, 1.78, 1.79, 1.80, 1.81, 1.82, 1.83, 1.84, 1.85, 1.86, 1.87, 1.88, 1.89, 1.90, 1.91, 1.92, 1.93, 1.94, 1.95, 1.96, 1.97, 1.98, 1.99, 2.00, 2.01, 2.02, 2.03, 2.04, 2.05, 2.06, 2.07, 2.08, 2.09, 2.10, 2.11, 2.12, 2.13, 2.14, 2.15, 2.16, 2.17, 2.18, 2.19 or 2.20. If the refractive index of the first electron transport layer is out of the above range, the optimal optical microcavity effect may not be achieved such that the luminescence efficiency of the device decreases and the full width at half maximum of the luminescence spectrum widens, which may reduce the color purity.

Preferably, the refractive index of the first electron transport layer may be 1.6 to 1.9, and more preferably 1.65 to 1.85. For example, the refractive indices of TPBi and ZADN that can be used in the first electron transport layer are 1.74 and 1.84, respectively.

In addition, the first electron transport layer may be applied without limitation to any material commonly used in the art, but preferably, it may be a material satisfying the above-described refractive index. For example, the first electron transport layer may include at least one selected from the group consisting of a compound including an aryl group and/or a heteroaryl group, a polymer of the compound and a derivative thereof, and specifically, it may include one or more selected from the group consisting of 2,2',2"-(1,3,5-benzinetriyl)-tris(1-phenyl-1-H-benzimidazole) (TPBi), 1,3,5-rri(m-pyridin-3-ylphenyl)benzene (TmPyPB), 4,6-bis(3,5-di(pyridin-3-yl)phenyl)-2-methylpyrimidine (B3PYMPM), 2,4,6-tris[3-(diphenylphosphinyl)phenyl]-1,3,5-triazine (PO-T2T), 3',3‴,3‴ʺ-(1,3,5-triazine-2,4,6-triyl) tris(([1,1'-biphenyl]-3-carbonitrile)) (CN-T2T), 2-[4-(9,10-di-naphthalen-2-yl-anthracen-2-yl)-phenyl]-1-phenyl-1H-benzoimidazole (ZADN), tris(2,4,6-trimethyl-3-(pyridin-3-yl)phenyl)borane (3TPYMB), Alq₃, 3-(biphenyl-4-yl)-5-(4-tert-butylphenyl)-4-phenyl-4H-1,2,4-triazole (TAZ), 4,7-diphenyl-1,10-phenanthroline (Bphen), 2,9-dimethyl-4,7-diphenyl-1,10-phenanthroline (BCP), bis(10-hydroxybenzo[h]quinolinato)beryllium (BeBq₂), 1,3,5-tri(p-pyrid-3-yl-phenyl)benzene (TpPyPB) and Bis(8-hydroxy-2-methylquinoline)-(4-phenylphenoxy)aluminum (BAlq).

FIG. 1f is a three-dimensional graph derived through optical simulation of the full width at half maximum of an electroluminescence spectrum according to the thicknesses of a second hole transport layer and a second electron transport layer of the organic light-emitting unit included in the tandem light-emitting device, which can be calculated by using a multi-layer thin-film OLED optical simulation method based on the classical dipole model described in research articles (Phys. Rev. B 85, 115205 (2012), Opt. Express 23, A279-A291 (2015), Nat. Commun. 5, 4769 (2014), Nat. Commun. 7, 11791 (2016)) and the like, or an optical simulation software package based on this method (e.g., J-OSTD (JooAm), SETFOS (FLUXim)).

The input parameters of the optical simulation include the light-emitting device structure and the refractive index and thickness of each layer, the photoluminescence quantum efficiency (PLQY) of the light-emitting layer, the photoluminescence spectrum of the light-emitting layer, the emitting dipole orientations of the light-emitting layer and the emission-zone distribution of the light-emitting layer, and each parameter may be obtained experimentally.

In this case, the refractive index of each layer may be obtained by measuring the thin film layer formed on the silicon substrate using a variable-angle spectroscopic ellipsometry method using an ellipsometer (e.g., J.A. Woollam M-2000) or by analyzing the fitting of the UV-Vis absorbance of the thin film layer formed on the quartz substrate using optical simulation. In addition, the PLQY of the light-emitting layer may be obtained by exciting each light-emitting-side thin film formed on a quartz substrate with a laser that generates appropriate absorption and then measuring the luminescence generated using an integrating sphere and a spectrometer connected thereto. In addition, the emitting dipole orientation of the light-emitting layer may be analyzed by optical simulation of the p-polarized angle-dependent photoluminescence generated by attaching each light-emitting layer formed on a quartz substrate to a half cylinder lens and then exciting the same with a laser, thereby obtaining the horizontal dipole orientation ratio and the vertical dipole orientation ratio through the optical simulation software package. Furthermore, the emission zone (EMZ) may be located in an actual light-emitting device by finding the matching point by comparing the angle-dependent photoluminescence measurements with the optical simulation results at each EMZ.

Based on the input parameters derived above, optical simulation may be performed through the following process. 1) The light-emitter inside the light-emitting layer is modeled as a classical dipole model to generate electromagnetic waves, and in this case, the emitting dipole is set to generate light by reflecting the experimentally measured dipole orientation ratio. The effective PLQY of the emitting dipole is calculated by applying the Purcell factor of the cavity where the emitting dipole is located to the experimentally measured PLQY of the thin film. 2) The reflection, transmission and refraction phenomena that occur when the electromagnetic wave generated from the emitting dipole reaches the thin film interface may be calculated by using the Fresnel equation, and these may be calculated by using the experimentally measured refractive index of each layer. 3) The multiple reflection, transmission, refraction and interference effects caused by the multi-layer structure of the actual device are calculated by using the transfer matrix method (TMM). Through this, the propagation of light in a light-emitting device with a multi-layer structure may be calculated, and the final spectrum may be calculated through this. For reference, the perovskite light-emitting layer of the present invention may be so thin that photon recycling may not be considered.

FIG. 3a shows a schematic diagram of a valley-centre tandem light-emitting device (an optimized light-emitting device, a light-emitting device in which the first and second electron transport layers have a multi-layer structure). Referring to FIG. 3a, the first electron transport layer may have a single-layer structure or a multi-layer structure, and preferably may have a multi-layer structure. Compared to a single-layer structure, a multi-layer structure provides more options for more appropriately selecting the thickness and material of each layer, which may be advantageous in achieving excellent microcavity effects and charge balance.

In the multi-layer structure, the materials included in each layer are different from each other, and the LUMO energy level of each layer in the first electron transport layer may increase as each layer gets closer to the perovskite light-emitting layer. Through this configuration, electrons generated in the charge generation layer may be effectively injected into the electron transport layer, thereby facilitating smoother electron transport, increasing the current density, and enhancing the luminescence efficiency

FIG. 13 shows the results of electrical and optical optimization according to the thickness of 2-[4-(9,10-Di-naphthalen-2-yl-anthracen-2-yl)-phenyl]-1-phenyl-1H-benzoimidazole (ZADN) among the first electron transport layers of the perovskite light-emitting unit included in the tandem light-emitting device of the present invention, and FIG. 14 shows the results of electrical and optical measurements according to the thickness of ZADN among the first electron transport layers of the perovskite light-emitting unit included in the tandem light-emitting device of the present invention, and the thickness of the first electron transport layer will be described with reference to FIGS. 13 and 14.

The thickness of the first electron transport layer may be, but is not limited to, 21 to 29 nm, and any thickness that can maximize the microcavity effect and balance the charge may be applied without limitation. For example, it may be 21.0, 21.5, 22.0, 22.5, 23.0, 23.5, 24.0, 24.5, 25.0, 25.5, 26.0, 26.5, 27.0, 27.5, 28.0, 28.5 or 29.0 nm.

Specifically, since the first electron transport layer is arranged close to the n-type charge generation layer, the thickness control thereof may be very important in terms of external quantum efficiency and color purity. If the thickness of the first electron transport layer is less than 21 nm or more than 29 nm, a charge imbalance may occur throughout the light-emitting device, or the optimal microcavity effect may not be expressed, resulting in insufficient color purity or disadvantages in external quantum efficiency. In particular, if it is more than 29 nm, although excellent external quantum efficiency is predicted in optical simulation, very low external quantum efficiency may be exhibited due to the charge imbalance.

In addition, when the first electron transport layer has a two-layer structure, the thickness of the layer having a lower LUMO energy level may be 17 to 23 nm, and the thickness of the layer having a higher LUMO energy level may be 4 to 6 nm. Specifically, the thickness of the layer having a lower LUMO energy level may be 17.0, 17.5, 18.0, 18.5, 19.0, 19.5, 20.0, 20.5, 21.0, 21.5, 22.0, 22.5 or 23.0 nm, and the thickness of the layer having a higher LUMO energy level may be 4.0, 4.5, 5.0, 5.5 or 6.0. For example, in the first electron transport layer, the layer with a lower LUMO energy level may include ZADN, and the layer with a higher LUMO energy level may include TPBi.

Next, the charge generation layer included in the tandem light-emitting device of the present invention will be described.

The charge generation layer may include an n-type charge generation layer that generates and injects electrons and/or a p-type charge generation layer that generates and injects holes, and due to the charge generation layer, electrons or holes may be injected into an adjacent light-emitting unit without resistance. In addition, the charge generation layer may electrically connect the perovskite light-emitting unit and the organic light-emitting unit, and supply electrons and holes to each unit.

The n-type charge generation layer or the p-type charge generation layer may have a single-layer structure or a multi-layer structure, and the present invention does not specifically limit the number of layers.

The n-type charge generation layer may be an organic material alone, which is an electron-transport material, or an organic material doped with an n-type dopant at a content of 5 to 40%. For example, the n-type dopant may be doped at a content of 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39 or 40%.

The electron transport material may be TPBI, TmPyPB, 3TPYMB, PO-T2T, BCP and the like. The n-type dopant may be an alkali metal, an alkaline earth metal, such as Li, Na, K, Rb, Cs, Mg, Ca or a carbonate series compound, an azide series compound, a nitride series compound, a nitrate series compound, a phosphate series compound or a quinolate series compound based thereon. Examples of compounds based on alkali metals or alkaline earth metals may include, but are not limited to, Li₂CO₃, LiNO₃, RbNO₃, Rb₂CO₃, AgNO₃, Ba(NO₃)₂, Mn(NO₃)₂, Zn(NO₃)₂, CsNO₃, Cs₂CO₃, CsF, CsN₃, FePo₄ and NaN₃.

The thickness of the n-type charge generation layer is not particularly limited, but may be 5 to 30 nm. For example, the thickness may be 5.0, 5.5, 6.0, 6.5, 7.0, 7.5, 8.0, 8.5, 9.0, 9.5, 10.0, 10.5, 11.0, 11.5, 12.0, 12.5, 13.0, 13.5, 14.0, 14.5, 15.0, 15.5, 16.0, 16.5, 17.0, 17.5, 18.0, 18.5, 19.0, 19.5, 20.0, 20.5, 21.0, 21.5, 22.0, 22.5, 23.0, 23.5, 24.0, 24.5, 25.0, 25.5, 26.0, 26.5, 27.0, 27.5, 28.0, 28.5, 29.0, 29.5 or 30.0 nm.

The p-type charge generation layer may be an organic material alone as a hole transport material or an organic material doped with a p-type dopant at a content of 5 to 40%. For example, the p-type dopant may be doped at a content of 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39 or 40%.

As the hole transport materials, TAPC, TCTA, TPD, NPB and CuPC may be used. The p-type dopant may be F4-TCNQ, FeCl₃, WO₃, MoO₃, ReO₃, Fe₃O₄, MnO₂, SnO₂, CoO₂, CuPC, a metal oxide, or a hole injection organic material having a deep LUMO level. Specifically, the p-type hole injection layer may be, but is not limited to, PEDOT:PSS, MoO₃, WO₃ and V₂O₅.

The thickness of the p-type charge generation layer is not particularly limited, but may be 5 to 30 nm. For example, the thickness thereof may be 5.0, 5.5, 6.0, 6.5, 7.0, 7.5, 8.0, 8.5, 9.0, 9.5, 10.0, 10.5, 11.0, 11.5, 12.0, 12.5, 13.0, 13.5, 14.0, 14.5, 15.0, 15.5, 16.0, 16.5, 17.0, 17.5, 18.0, 18.5, 19.0, 19.5, 20.0, 20.5, 21.0, 21.5, 22.0, 22.5, 23.0, 23.5, 24.0, 24.5, 25.0, 25.5, 26.0, 26.5, 27.0, 27.5, 28.0, 28.5, 29.0, 29.5 or 30.0 nm.

An organic light-emitting unit included in the tandem light-emitting device according to the present invention will be specifically described. The organic light-emitting unit is disposed on the charge generation layer, and includes a second hole transport layer, an organic light-emitting layer and a second electron transport layer.

The refractive index of the second hole transport layer may be, but is not limited to, in the range of 1.4 to 2.2. For example, the refractive index of the second hole transport layer based on 531 nm may be 1.40, 1.41, 1.42, 1.43, 1.44, 1.45, 1.46, 1.47, 1.48, 1.49, 1.50, 1.51, 1.52, 1.53, 1.54, 1.55, 1.56, 1.57, 1.58, 1.59, 1.60, 1.61, 1.62, 1.63, 1.64, 1.65, 1.66, 1.67, 1.68, 1.69, 1.70, 1.71, 1.72, 1.73, 1.74, 1.75, 1.76, 1.77, 1.78, 1.79, 1.80, 1.81, 1.82, 1.83, 1.84, 1.85, 1.86, 1.87, 1.88, 1.89, 1.90, 1.91, 1.92, 1.93, 1.94, 1.95, 1.96, 1.97, 1.98, 1.99, 2.00, 2.01, 2.02, 2.03, 2.04, 2.05, 2.06, 2.07, 2.08, 2.09, 2.10, 2.11, 2.12, 2.13, 2.14, 2.15, 2.16, 2.17, 2.18, 2.19 or 2.20. If the refractive index of the second hole transport layer is out of the above range, the optimal optical microcavity effect may not be achieved such that the luminescence efficiency of the device decreases and the full width at half maximum of the luminescence spectrum widens, thereby reducing the color purity.

Preferably, the refractive index of the second hole transport layer may be 1.6 to 1.9, and more preferably 1.65 to 1.85. For example, the refractive index of TAPC that may be used in the second hole transport layer is 1.71.

In addition, the second hole transport layer may be applied without limitation to any material commonly used in the art, but preferably, it may be a material satisfying the above-described refractive index. For example, the second hole transport layer may include at least one selected from the group consisting of a compound containing an aryl group and/or a heteroaryl group, a polymer of the compound and a derivative thereof, and specifically, it may include one or more selected from the group consisting of 4,4'-cyclohexylidenebis[N,N-bis(4-methylphenyl)benzenamine] (TAPC), 4,4',4"-tris(carbazol-9-yl)triphenylamine (TCTA), N,N'-di(1-naphthyl)-N,N'-diphenyl-(1,1'-biphenyl)-4,4'-diamine (NPB), 4,4'-bis(9-carbazolyl)-1,1'-biphenyl (CBP), poly[N,N'-bis(4-butylphenyl)-N,N'-bisphenylbenzidine] (Poly-TPD), polyaniline (PANI), poly(n-vinylcarbazole) (PVK), poly[bis(4-phenyl)(2,4,6-trimethylphenyl)amine (PTAA) and Buf-HIL.

The second hole transport layer may have a single-layer structure or a multi-layer structure, and the present invention does not particularly limit the same.

In addition, the second hole transport layer may be a hole injection layer.

The organic light-emitting layer includes a host and/or a dopant, wherein the host may contain one or more selected from the group consisting of CBP, TCTA, mCP, DCzPPy, PCPPn, PCPN, CzTP, TCPB and CzPA, and the dopant may contain one or more selected from the group consisting of a fluorescent organic material, a phosphorescent organic material, and a thermally activated delayed fluorescent organic material.

The fluorescent organic compound may be at least one of 4-(dicyanomethylene)-2-t-butyl-6-(1,1,7,7-tetramethyljulolidyl-9-enyl)-4Hpyran (DCJTB), (E)-2-(2-(4-(dimethylamino)styryl)-6-methyl-4H-pyran-4-ylidene)malononitrile (DCM), and 5,6-bis(4-(9,9-dimethylacridin-10(9H)-yl)phenyl)pyrazine-2,3-dicarbonitrile (Ac-CNP).

The phosphorescent organic material may be at least one among Bt2Ir(acac), tris(1-phenylisoquinoline) iridium(III) (Ir(piq)₃), bis(2-(3,5-dimethylphenyl)-4-phenylpyridine)(2,2,6,6-tetramethylheptane-3,5-diketonate)iridium(III) (Ir(dmppyph)₂tmd), bis(2-benzo[b ]thiophen-2-yl-pyridine)(acetylacetonate)iridium(III) (Ir(btp)₂(acac)), bis[1-(9,9-dimethyl-9H-fluoren-2-yl)-isoquinoline](acetylacetonate)iridium(III) (Ir(fliq)₂(acac)), bis[2-(9,9-dimethyl-9H-fluoren-2-yl)quinoline](acetylacetonate)iridium(III) (Ir(flq)₂(acac)), bis[2-(4-nhexylphenyl)quinoline](acetylacetonate)iridium(III) (Hex-Ir(phq)₂(acac)), tris[2-(4-nhexylphenyl)quinoline]iridium(III) (hex-Ir(phq)₃ and bis(2-phenylquinoline)(2-(3-methylphenyl)pyridinate)iridium(III) (Ir(phq)₂tpy).

The thermally activated delayed fluorescent (TADF) organic material may be at least one of dibenzo{[f,f']-4,4',7,7'-tetraphenyl}diindeno[1,2,3-cd:1',2',3'-lm]perylene(DBP), 2,3,5,6-tetrakis[3,6-bis(1,1-dimethylethyl)-9H-carbazol-9-yl]benzonitrile(4CzBN), 7,10-bis(4-(diphenylamino)phenyl)-2,3-dicyanopyrazino phenanthrene(TPA-DCPP), 2,8-di-tert-butyl-5,11-bis(4-tert-butylphenyl)-6,12-diphenyltetracene(TBRb) and 2-(9-phenyl-9H-carbazol-3-yl)-10,10-dioxide-9H-thioxanthen-9-one(TXO-PhCz).

The organic light-emitting layer may have a single-layer structure or a multi-layer structure, and the present invention does not specifically limit the same. Preferably, it may have a multi-layer structure, and more preferably, in the organic light-emitting layer, the HOMO energy level of each layer may increase as each layer gets closer to the second hole transport layer, and the LUMO energy level of each layer may decrease as each layer gets closer to the second electron transport layer.

The thickness of the above organic light-emitting layer may be 1 to 100 nm, but is not particularly limited. For example, it may be 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 32, 34, 36, 38, 40, 42, 44, 46, 48, 50, 52, 54, 56, 58, 60, 65, 70, 75, 80, 85, 90, 95 or 100 nm.

The refractive index of the second electron transport layer may be, but is not limited to, in the range of 1.4 to 2.2. For example, the refractive index of the second electron transport layer at 531 nm may be 1.40, 1.41, 1.42, 1.43, 1.44, 1.45, 1.46, 1.47, 1.48, 1.49, 1.50, 1.51, 1.52, 1.53, 1.54, 1.55, 1.56, 1.57, 1.58, 1.59, 1.60, 1.61, 1.62, 1.63, 1.64, 1.65, 1.66, 1.67, 1.68, 1.69, 1.70, 1.71, 1.72, 1.73, 1.74, 1.75, 1.76, 1.77, 1.78, 1.79, 1.80, 1.81, 1.82, 1.83, 1.84, 1.85, 1.86, 1.87, 1.88, 1.89, 1.90, 1.91, 1.92, 1.93, 1.94, 1.95, 1.96, 1.97, 1.98, 1.99, 2.00, 2.01, 2.02, 2.03, 2.04, 2.05, 2.06, 2.07, 2.08, 2.09, 2.10, 2.11, 2.12, 2.13, 2.14, 2.15, 2.16, 2.17, 2.18, 2.19 or 2.20. If the refractive index of the second electron transport layer is out of the above range, the optimal optical microcavity effect may not be achieved such that the luminescence efficiency of the device decreases and the full width at half maximum of the luminescence spectrum widens, which may reduce the color purity.

Preferably, the refractive index of the second electron transport layer may be 1.6 to 1.9, and more preferably 1.65 to 1.85. For example, the refractive indices of TPBi and ZADN that can be used in the second electron transport layer are 1.74 and 1.84, respectively.

In addition, the second electron transport layer may be applied without limitation to any material commonly used in the art, but preferably, it may be a material satisfying the above-described refractive index. For example, the second electron transport layer may include at least one selected from the group consisting of a compound containing an aryl group and/or a heteroaryl group, a polymer and derivative of the compound, and specifically, it may include one or more selected from the group consisting of 2,2',2"-(1,3,5-benzinetriyl)-tris(1-phenyl-1-H-benzimidazole) (TPBi), 1,3,5-tri(m-pyridin-3-ylphenyl)benzene(TmPyPB), 4,6-bis(3,5-di(pyridin-3-yl)phenyl)-2-methylpyrimidine(B3PYMPM), 2,4,6-tris[3-(diphenylphosphinyl)phenyl]-1,3,5-triazine (PO-T2T), 3',3‴,3‴ʺ-(1,3,5-triazine-2,4,6-triyl) tris(([1,1'-biphenyl]-3-carbonitrile)) (CN-T2T), 2-[4-(9,10-di-naphthalen-2-yl-anthracen-2-yl)-phenyl]-1-phenyl-1H-benzoimidazole(ZADN), tris(2,4,6-trimethyl-3-(pyridin-3-yl)phenyl)borane (3TPYMB), Alq₃, 3-(biphenyl-4-yl)-5-(4-tert-butylphenyl)-4-phenyl-4H-1,2,4-triazole (TAZ), 4,7-diphenyl-1,10-phenanthroline(Bphen), 2,9-dimethyl-4,7-diphenyl-1,10-phenanthroline (BCP), bis(10-hydroxybenzo[h]quinolinato)beryllium (BeBq₂), 1,3,5-tri(p-pyrid-3-yl-phenyl)benzene (TpPyPB) and bis(8-hydroxy-2-methylquinoline)-(4-phenylphenoxy)aluminum (BAlq).

FIG. 3a shows a schematic diagram of a valley-centre tandem light-emitting device (an optimized light-emitting device, a light-emitting device in which the first and second electron transport layers have a multi-layer structure), and when it is described by referring to FIG. 3a, the second electron transport layer may have a single-layer structure or a multi-layer structure, and preferably may have a multi-layer structure. Compared to a single-layer structure, a multi-layer structure provides more options for more appropriately selecting the thickness and material of each layer, which may be advantageous in achieving excellent microcavity effects and charge balance.

In the multi-layer structure, the materials included in each layer are different from each other, and the LUMO energy level of each layer in the second electron transport layer may increase as each layer gets closer the perovskite light-emitting layer, thereby making electron transport smoother and increasing the current density and luminescence efficiency.

In addition, more preferably, both of the first and second electron transport layers may have a multi-layer structure. In the case where both have a multi-layer structure, the color purity and external quantum efficiency may be superior compared to the case where even one layer has a single layer structure.

Specifically, a tandem light-emitting device in which the first and second electron transport layers are all multi-layer structures and a tandem light-emitting device in which the first and second electron transport layers are not all multi-layer structures will be compared and explained.

FIG. 3b shows the results of voltage-current density measurements for each of the organic light-emitting unit and the perovskite light-emitting unit included in the valley-centre tandem light-emitting device and the unbalanced tandem light-emitting device 1 (a non-optimized light-emitting device, a tandem light-emitting device in which the first and second electron transport layers are not multi-layer structures), FIG. 3d shows the results of voltage-external quantum efficiency measurements for the valley-centre tandem light-emitting device and the unbalanced tandem light-emitting device 1, FIG. 3f shows the results of external quantum efficiency through optical simulation and actually measured external quantum efficiency for the valley-centre tandem light-emitting device and the unbalanced tandem light-emitting device 1, and FIG. 3i shows the results of normalized electroluminescence spectra through optical simulation and actually measured normalized electroluminescence spectra for the valley-centre tandem light-emitting device, the perovskite light-emitting device, and the organic light-emitting device.

As can be seen from FIGS. 3b, 3d, 3f and 3i, the tandem light-emitting device in which the first and second electron transport layers are all multi-layer structures may exhibit high external quantum efficiency as predicted by the optical simulation because the current densities of the perovskite light-emitting unit and the organic light-emitting unit are completely matched at the applied voltage of 2.6 to 3.2 V of each unit. On the other hand, the tandem light-emitting device in which the first and second electron transport layers are not all multi-layer structures may exhibit lower external quantum efficiency than the optical simulation prediction because the current densities of the perovskite light-emitting unit and the organic light-emitting unit are mismatched at the applied voltage of 2.6 to 3.2 V of each unit, and may exhibit lower external quantum efficiency than the light-emitting device having a multi-layer structure.

In addition, FIG. 3e is the results of measuring normalized electroluminescence spectra for a valley-centre tandem light-emitting device and an unbalanced tandem light-emitting device 1, wherein a tandem light-emitting device in which both the first and second electron transport layers have a multi-layer structure may have a smaller full width at half maximum than a tandem light-emitting device in which the first and second electron transport layers are not all multi-layer structures, even if the thicknesses of the first electron transport layer, the second hole transport layer and the second electron transport layer are the same, thereby enabling excellent color purity. This is because the electroluminescence spectrum is shifted and expanded in the case of a tandem light-emitting device that does not have a multi-layer structure.

In addition, FIG. 3g is the results for the peak shift of the normalized electroluminescence spectrum according to the driving voltage in the unbalanced tandem light-emitting device 1, and FIG. 3h is the results for the peak shift of the normalized electroluminescence spectrum according to the driving voltage in the valley-centre tandem light-emitting device. When it is described by referring to FIGS. 3g and 3h, in the tandem light-emitting device in which both the first and second electron transport layers have a multi-layer structure, the electroluminescence spectrum peak does not shift even when the applied voltage changes, but in the tandem light-emitting device in which both the first and second electron transport layers do not have a multi-layer structure, the electroluminescence spectrum peak shifted and expanded according to the applied voltage changes. This may be a phenomenon caused by the charge imbalance of the tandem light-emitting device that does not have a multi-layer structure.

A tandem light-emitting device in which the first and second electron transport layers are all multi-layer structures and a tandem light-emitting device in which at least one layer is a single-layer structure will be compared and explained.

FIG. 4 shows the results of electrical optimization according to the presence or absence of a multi-layer structure in the electron transport layer included in the tandem light-emitting device. When it is described by referring thereto, a tandem light-emitting device having even a single-layer structure may have lower external quantum efficiency than the optical simulation prediction due to mismatch in the current densities of the perovskite light-emitting unit and the organic light-emitting unit at the applied voltage of 2.6 to 3.2 V of each unit, and may have lower external quantum efficiency than a light-emitting device having an entirely multi-layer structure. In addition, the full width at half maximum may be small, resulting in insufficient color purity.

FIG. 5 shows the results of the peak shift of the electroluminescence spectrum according to the driving voltage in an unbalanced light-emitting device and a valley-centre tandem light-emitting device. Referring to this, in the case of a tandem light-emitting device having a single-layer structure at least in one layer, the peak of the electroluminescence spectrum shifted and expanded according to the change in the applied voltage, and this may be a phenomenon caused by the charge imbalance of the tandem light-emitting device having a single-layer structure at least in one layer.

Furthermore, FIG. 6 shows the results of transient electroluminescence intensity measurements for an unbalanced light-emitting device (a tandem light-emitting device in which at least one of the first and second electron transport layers is not a multi-layer structure) and a valley-centre tandem light-emitting device. As shown in FIG. 6, a tandem light-emitting device in which all of the first and second electron transport layers are a multi-layer structure may exhibit a faster turn-on response than a tandem light-emitting device in which at least one of the first and second electron transport layers is not a multi-layer structure. This may be because charge carrier injection of the tandem light-emitting device having an entirely multi-layer structure is improved due to the multi-layer structure and the optimized thickness, and the charge balance is very excellent.

When it is described by referring to FIG. 1 and FIG. 7 to FIG. 11, the tandem light-emitting device of the present invention controls the thickness of the second hole transport layer and the second electron transport layer such that the emission spectrum full width at half maximum of the entire tandem light-emitting device satisfies Relationship Formula 1 below, wherein the full width at half maximum means the width of the spectrum at a height corresponding to half the wavelength of the maximum wavelength of the emission spectrum. <Relationship Formula 1> $FWHM \left(PeLED\right) \leq FWHM \left(tandem\right) \leq FWHM \left(OLED\right)$

In this case, the FWHM (OLED) is the full width at half maximum of a light-emitting device that includes an organic light-emitting unit and does not include a perovskite light-emitting unit, the FWHM (tandem) is the full width at half maximum of the tandem light-emitting device, and the FWHM (PeLED) is the full width at half maximum of a light-emitting devices that includes a perovskite light-emitting unit and does not include an organic light-emitting unit.

Since the light-emitting device of the present invention is of a tandem type and includes both an organic light-emitting unit and a perovskite light-emitting unit, the FWHM (tandem) has a value between the FWHM (OLED) and the FWHM (PeLED). Through this, the tandem light-emitting device may have both the advantage of an organic light-emitting unit having high luminescence efficiency and the advantage of a perovskite light-emitting unit having high color purity.

In addition, the tandem light-emitting device may satisfy FWHM (tandem) ≤ (FWHM (OLED)+FWHM (PeLED))/2. Preferably, it may satisfy FWHM (tandem) ≤ (FWHM (OLED)+FWHM (PeLED))/2 while satisfying Relationship Formula 1 above. Through this, the tandem light-emitting device of the present invention may have a full width at half maximum close to that of a perovskite light-emitting device with excellent full width at half maximum, rather than simply having an intermediate value between the full width at half maximum of the perovskite light-emitting layer and the full width at half maximum of the organic light-emitting layer such that high color purity can be ensured.

The tandem light-emitting device may have all of the above-described advantages by controlling the thicknesses of the second hole transport layer and the second electron transport layer. If the thicknesses are not controlled, the microcavity effect may not occur effectively or a charge imbalance may occur, resulting in insufficient color purity, reduced luminescence efficiency and reduced operating lifetime compared to when the thicknesses are controlled.

The thickness of the second hole transport layer and the thickness of the second electron transport layer may satisfy Relationship Formula 2 below and/or Relationship Formula 3 below. <Relationship Formula 2> $a \leq x + by \leq c$

In this case, in Relationship Formula 2, x is the thickness of the second electron transport layer, y is the thickness of the second hole transport layer, a is - 89.474×n + 265.001, b is -1.053×n + 2.931, c is -63.158×n + 243.001, and wherein n is the refractive index of the second hole transport layer. Here, n may be preferably in the range of 1.4 to 2.2, which corresponds to the refractive index range of the second hole transport layer described above, thereby maximizing luminescence efficiency or color purity. <Relationship Formula 3> $d \leq x + ey \leq f$

In this case, in Relationship Formula 3, x is the thickness of the second electron transport layer, and y is the thickness of the second hole transport layer,

d is 15.789×m + 82.95, e is 1.105×m-0.903, f is 135, and wherein m is the refractive index of the second electron transport layer. Here, m may be preferably in the range of 1.4 to 2.2, which corresponds to the refractive index range of the second electron transport layer described above, and through this, luminescence efficiency or color purity may be maximized.

When Relationship Formula 2 above and/or Relationship Formula 3 above are satisfied, the microcavity effect is maximized and charge balance may be achieved such that the full width at half maximum of the electroluminescence spectrum of the entire device is reduced, and thus, the color purity may be very excellent, and the luminescence efficiency such as the external quantum efficiency may be maximized.

Specifically, FIG. 1f and FIG. 7 are examples showing the results of the full width at half maximum according to the thickness of the second hole transport layer and the thickness of the second electron transport layer in a tandem light-emitting device through optical simulation, and when the ranges of Relationship Formula 2 above and/or Relationship Formula 3 above are satisfied, the full width at half maximum may be maintained low.

More specifically, FIG. 8 shows electrical and optical measurement results for tandem light-emitting devices (Valley 1, Vally 2 and Vally-centre tandem) that satisfied Relationship Formula 2 above and/or Relationship Formula 3 above and tandem light-emitting devices (Off-Valley 1 and Off-Valley 2) that did not satisfy the same. The devices satisfying Relationship Formula 2 above and/or Relationship Formula 3 above may have superior luminance according to voltage, may have superior color purity due to a lower full width at half maximum, and may be close to Lambertian reflectance compared to the devices that do not satisfy them.

In addition, FIG. 9a is the optical simulation results for the external quantum efficiency of the entire device, according to the thicknesses of the second hole transport layer and the second electron transport layer of the organic light-emitting unit included in the tandem light-emitting device, and FIGS. 9g to 9i are normalized electroluminescence spectra and full width at half maximum results of the optical simulation of the entire light-emitting device, the perovskite light-emitting unit and the organic light-emitting unit in the valley-centre tandem light-emitting device and the thick tandem light-emitting device. Considering these, it is predicted that the thick tandem light-emitting device that deviates from Relationship Formula 2 above and/or Relationship Formula 3 above will have a larger full width at half maximum but higher external quantum efficiency than the valley-centre tandem light-emitting device that does not deviate from the same.

However, FIGS. 9d to 9f are measurement results of external quantum efficiency and electroluminescence spectra of a valley-centre tandem light-emitting device and a thick tandem light-emitting device, and it was measured that the valley-centre tandem light-emitting device had higher external quantum efficiency and smaller full width at half maximum. In addition, FIGS. 10 and 11 are analysis results of a emission zone of a valley-centre tandem light-emitting device and electroluminescence spectra depending on an angle for the valley-centre tandem light-emitting device and the thick tandem light-emitting device, and it was found that the valley-centre tandem light-emitting device may be closer to Lambertian reflection than the thick tandem light-emitting device. Therefore, the reason why valley-centre tandem light-emitting devices have a better full width at half maximum than thick tandem light-emitting devices, are closer to Lambertian reflection and have better external quantum efficiency than optical simulation predictions is because valley-centre tandem light-emitting devices can achieve a charge balance close to 100%, whereas thick tandem light-emitting devices incur a large amount of electrical loss due to charge imbalance.

Meanwhile, FIG. 12 is the simulation results of relative electroluminescence spectra according to angle for a valley-centre tandem light-emitting device, a thick tandem light-emitting device and an off-valley tandem light-emitting device, wherein a tandem light-emitting device (e.g., a valley-centre tandem light-emitting device) that does not deviate from Relationship Formula 2 above and/or Relationship Formula 3 above may exhibit the most intense light emission at a viewing angle of 0°, and the change in color purity according to the viewing angle may be most suppressed. Through this, a tandem light-emitting device satisfying Relationship Formula 2 above and/or Relationship Formula 3 above may achieve high color purity and luminance at a viewing angle of 0°, which is the most important, when it is used in a display device.

As a result, a tandem light-emitting device satisfying Relationship Formula 2 above and/or Relationship Formula 3 above may be superior to a device that does not satisfy the same in terms of not only the full width at half maximum but also the external quantum efficiency, and when it is used in a display device, it may be very excellent at a viewing angle of 0°, which is the most important, and may have less change in color purity depending on the viewing angle.

In addition, when it is described by referring to FIGS. 7 and 8, when Relationship Formula 2 above and/or Relationship Formula 3 above are satisfied, the thickness of the second hole transport layer may be 50 to 80 nm, and the thickness of the second electron transport layer may be 40 to 60 nm. For example, the thickness of the second hole transport layer may be 50, 51, 52, 53, 54, 55, 56, 57, 58, 59, 60, 61, 62, 63, 64, 65, 66, 67, 68, 69, 70, 71, 72, 73, 74, 75, 76, 77, 78, 79 or 80 nm, and the thickness of the second electron transport layer may be 40, 41, 42, 43, 44, 45, 46, 47, 48, 49, 50, 51, 52, 53, 54, 55, 56, 57, 58, 59 or 60 nm. If the thickness of the second hole transport layer and the thickness of the second electron transport layer are out of the ranges, the microcavity effect, which is advantageous for implementing a narrow full width at half maximum, may be distorted, resulting in low color purity by exceeding a full width at half maximum of 30 nm.

In addition, when it is described by referring to FIG. 3b, when Relationship Formula 2 above and/or Relationship Formula 3 above are satisfied, the perovskite light-emitting unit and the organic light-emitting unit may satisfy Relationship Formula 4 below. <Relationship 4 Formula> $0.8 \leq A / B \leq 1.2$

In this case, A is the current density of a perovskite light-emitting unit when the applied voltage to the perovskite light-emitting unit is 2.8 V, and B is the current density of an organic light-emitting unit when the applied voltage to the organic light-emitting unit is 2.8 V.

If Relationship Formula 4 is not satisfied, charge imbalance may occur in the tandem light-emitting device, which may reduce color purity and luminescence efficiency. This can be confirmed through FIGS. 3 to 5 as described above.

The above-described tandem light-emitting device may further include at least one of an electron injection layer, a hole injection layer and an insulating intermediate layer.

The electron injection layer may be, but is not limited to, LiF and/or Liq, and the thickness thereof is not limited as long as it can be commonly applied in the art, but is not particularly limited in the present invention.

Likewise, there is no limitation on the types and thicknesses of the hole injection layer and the insulating intermediate layer as long as they are used in the art.

Furthermore, the electron injection layer, hole injection layer and insulating intermediate layer may have a single-layer structure or a multi-layer structure, and the present invention does not particularly limit the same.

FIG. 2a shows the results of voltage-current density measurements for a tandem light-emitting device, a perovskite light-emitting device and an organic light-emitting device, and FIG. 2b shows the results of voltage-luminance measurements. As shown in FIGS. 2a and 2b, the tandem light-emitting device may have a current efficiency (CE) of 100 cd/A or more. For example, when the current efficiency is calculated through the luminance and current density of each device shown in FIGS. 2a and 2b, the current efficiency of the tandem light-emitting device according to a preferred embodiment of the present invention may be 151.8 cd/A, the perovskite light-emitting device may be 66.2 cd/A, and the organic light-emitting device may be 76.5 cd/A.

FIG. 2c is the results of luminance-external quantum efficiency (EQE) measurements for a tandem light-emitting device, a perovskite light-emitting device and an organic light-emitting device, and FIG. 2e is a graph expressing the results of external quantum efficiency for a conventional perovskite light-emitting device and a tandem light-emitting device according to a preferred embodiment of the present invention. As shown in FIGS. 2c and 2e, the tandem light-emitting device may have an external quantum efficiency of 30% or more. For example, the external quantum efficiency may be 30, 31, 32, 33, 34, 35, 36, 37, 38, 39, 40, 41, 42, 43, 44, 45, 46, 47, 48, 49, 50, 52, 54, 56, 58, 60, 62, 64, 66, 68, 70, 72, 74, 76, 78, 80, 82, 84, 86, 88, 90, 92, 94, 96, 98 or 100%. Preferably, the external quantum efficiency may be greater than or equal to 35%.

FIG. 2d is the normalized electroluminescence (EL) spectra measurement results for a tandem light-emitting device, a perovskite light-emitting device and an organic light-emitting device. As shown in FIG. 2d, the tandem light-emitting device may have a full width at half maximum of 30 nm or less. For example, it may be 1, 2, 3, 4, 5, 6, 7, 8, 9, 10, 11, 12, 13, 14, 15, 16, 17, 18, 19, 20, 21, 22, 23, 24, 25, 26, 27, 28, 29 or 30 nm. Preferably, the full width at half maximum may be 28 nm or less. If the full width at half maximum can be maintained at 30 nm or less, the color purity may be excellent.

FIG. 2f shows the results of normalized transient EL intensity measurements for a tandem light-emitting device, a perovskite light-emitting device and an organic light-emitting device. When it is described by referring to FIG. 2f, the tandem light-emitting device may have an improved turn-off or turn-on response (response) time compared to the perovskite light-emitting device or the organic light-emitting device, respectively. The perovskite light-emitting layer has higher charge carrier movement characteristics than the organic light-emitting layer, and thus has an improved turn-on response time compared to the organic light-emitting layer. However, it has an inferior turn-off response time compared to the organic light-emitting layer due to ion movement and charge carrier trapping phenomena. In a tandem light-emitting device including all of the light-emitting layers, the turn-on response time is improved to be close to the level of the perovskite light-emitting device, and the turn-off response time is improved to be close to the level of the organic light-emitting device, and thus, the turn-on and turn-off responses may be greatly improved compared to a single unit device.

FIG. 2g is a streak camera image captured photographed for 500 µs during the turn-on process of the tandem light-emitting device of the present invention, and FIG. 2h is the results of measuring a time-resolved spectra for 500 µs during the turn-on process of the tandem light-emitting device of the present invention. When it is described by referring to FIGS. 2g and 2h, the tandem light-emitting device may stably exhibit an emission spectrum when the operating time is 400 µs or longer.

Finally, as can be seen from FIGS. 2f to 2h, the perovskite light-emitting layer and the organic light-emitting layer included in the tandem light-emitting device of the present invention uniformly contribute to electroluminescence while simultaneously responding to voltage pulses, and thus, the tandem light-emitting device may have excellent turn-on and turn-off characteristics.

Meanwhile, FIG. 15 shows the results of measuring the lifetime of the tandem light-emitting device and perovskite light-emitting device of the present invention. Considering this, the tandem light-emitting device may have an operating lifetime of 3,000 hours or more under an electrical stress state of *L*₀ = 100 cd/m². Preferably, it may be 5,000 hours or more. Since the tandem light-emitting device includes multiple light-emitting layers, as the voltage applied to each light-emitting layer decreases, the electrical stress required to achieve the same luminance as a single light-emitting device decreases, and thus, the operating lifetime may be improved.

In addition, the tandem light-emitting device may have a peak in the wavelength range of 500 to 550 nm of the emission spectrum, but is not limited thereto. If it has a peak in the wavelength range, the tandem light-emitting device may emit light in the green visible light region.

By appropriately changing the material type and thickness of each layer of the tandem light-emitting device, a light-emitting device having high color purity and high luminescence efficiency while having an emission spectrum peak in a wavelength range different from the above range may be implemented.

In order to solve the above-described problems, provided is a display device including the above-described tandem light-emitting device.

The display device may be large-area and flexible. In addition, the display device may include the above-described tandem light-emitting device such that color purity and luminescence efficiency is maximized, on-off response is improved, operating lifetime is excellent, and manufacturing cost is low.

In order to solve the above-described problems, provided is a method for manufacturing a tandem light-emitting device, including: 1) forming a perovskite light-emitting unit by sequentially forming a first hole transport layer, a perovskite light-emitting layer and a first electron transport layer on a first electrode; (2) forming a charge generation layer on the first electron transport layer; (3) forming an organic light-emitting unit by sequentially forming a second hole transport layer, an organic light-emitting layer and a second electron transport layer on the charge generation layer; and (4) forming a second electrode on the second electron transport layer, wherein by controlling thicknesses of the second hole transport layer and the second electron transport layer, a full width at half maximum (FWHM) of an emission spectrum of the entire tandem light-emitting device satisfies Relationship Formula 1 below: <Relationship Formula 1> $FWHM \left(PeLED\right) \leq FWHM \left(tandem\right) \leq FWHM \left(OLED\right)$
wherein the FWHM (OLED) is a full width at half maximum of a light-emitting device that includes an organic light-emitting unit and does not includes a perovskite light-emitting unit, wherein the FWHM (tandem) is a full width at half maximum of the tandem light-emitting device, and wherein the FWHM (PeLED) is a full width at half maximum of a light-emitting device that includes a perovskite light-emitting unit and does not include an organic light-emitting unit.

The above-described method for manufacturing a tandem light-emitting device may manufacture the above-described tandem light-emitting device. Therefore, any content that overlaps with the content regarding the above-described tandem light-emitting device will be omitted.

First of all, in step (1), a first hole transport layer, a perovskite light-emitting layer and a first electron transport layer are sequentially formed on a first electrode to form a perovskite light-emitting unit.

The first electrode may be prepared on a substrate, and since the first electrode is the same as described above, it will be omitted.

The substrate may be any substrate commonly used in the art, and is not particularly limited thereto in the present invention. For example, the substrate may be a flexible material or a hard material. Preferably, the substrate may be a metal substrate such as carbon (C), iron (Fe), chromium (Cr), manganese (Mn), nickel (Ni), titanium (Ti), molybdenum (Mo) or stainless steel (SUS); a plastic substrate such as polyethylene naphthalate (PEN), polyethylene terephthalate (PET), polyphenylene sulfide (PPS), polyallylate, polyimide, polyetherimide (PEI), polyacrylate (PAR) or polycarbonate; a glass substrate; a sapphire substrate, a quartz substrate, a silicon substrate or any combination thereof.

Since the first hole transport layer and the perovskite light-emitting layer are the same as described above, specific details will be omitted.

The first hole transport layer and/or the perovskite light-emitting layer may be deposited through a solution process, but is not limited thereto. In this case, the solution process may be any general solution process used in the art, such as a spin coating process, a slot die coating process, a blade coating process, a printing coating process, a gravure coating process or a spray coating process.

Since the first electron transport layer is the same as described above, specific details will be omitted.

The first electron transport layer may be deposited through a dry process, but is not limited thereto. In this case, the dry process may be any general dry process used in the art, such as a thermal evaporation process, a vacuum deposition process, an atomic layer deposition (ALD) process, a chemical vapor deposition (CVD) process, a physical vapor deposition (PVD) process, an air jet process or the like.

Next, in step (2), a charge generation layer is formed on the first electron transport layer formed in step (1).

Since the charge generation layer is the same as described above, specific details will be omitted.

The charge generation layer may be deposited through a dry process, but is not limited thereto. In this case, the dry process may be any general dry process used in the art, such as a thermal evaporation process, a vacuum deposition process, an atomic layer deposition (ALD) process, a chemical vapor deposition (CVD) process, a physical vapor deposition (PVD) process, an air jet process or the like.

Next, in step (3), a second hole transport layer, an organic light-emitting layer and a second electron transport layer are sequentially formed on the charge generation layer formed in step (2) to form an organic light-emitting unit.

Since the second hole transport layer, the organic light-emitting layer and the second electron transport layer are the same as described above, specific details will be omitted.

At least one of the second hole transport layer, the organic light-emitting layer and the second electron transport layer may be deposited through a dry process, but is not limited thereto. In this case, the dry process may be any general dry process used in the art, such as a thermal evaporation process, a vacuum deposition process, an atomic layer deposition (ALD) process, a chemical vapor deposition (CVD) process, a physical vapor deposition (PVD) process, an air jet process or the like.

Next, in step (4), a second electrode is formed on the second electron transport layer formed in step (3).

Since the second electrode is the same as described above, specific details will be omitted.

The second electrode may be deposited through a dry process, but is not limited thereto. In this case, the dry process may be any general dry process used in the art, such as a thermal evaporation process, a vacuum deposition process, an atomic layer deposition (ALD) process, a chemical vapor deposition (CVD) process, a physical vapor deposition (PVD) process, an air jet process or the like.

Meanwhile, the method for manufacturing a tandem light-emitting device of the present invention may be manufactured at a low cost by using only two units, while also using a perovskite light-emitter, which is cheaper than an organic light-emitter.

The present invention will be described more specifically through the following examples, but the following examples do not limit the scope of the present invention, and should be interpreted as helping to understand the present invention.

### <Example>

### Example 1

Oleic acid (90.0%, Alfa Aesar), n-decylamine (98.0%, TCI), guanidinium bromide (GABr, >99%, GreatCell Solar), formamidinium bromide (FABr, >99.99%, GreatCell Solar), lead(II) bromide (PbBr₂, 99.999%, Sigma-Aldrich), toluene (99.5%, Samchun Chemicals), 1-butyl alcohol (99.0%, Samchun Chemicals) and N,N-dimethylformamide (>99.8%, Sigma-Aldrich) were prepared as synthetic materials. The synthetic materials described above were used without any treatment.

Molybdenum oxide (MoO₃, 99.97%, Sigma-Aldrich), lithium nitride (Li₃N, ≥99.50%, Sigma-Aldrich), ZADN (2-[4-(9,10-di-naphthalen-2-yl-anthracen-2-yl)-phenyl]-1-phenyl-1H-benzoimidazole, >99%, Suzhou Geao New Material), BCP (Bathocuproine, OSM), TPBi (2,2',2"-(1,3,5-benzinetriyl)-tris(1-phenyl-1H-benzimidazole, >99.9%, OSM), TAPC (1,1-bis[(di-4-tolylamino)phenyl]cyclohexane, >99.9%, OSM), TCTA (tris(4-carbazoyl-9-ylphenyl)amine, >99.9%, OSM), CBP (4,4'-bis(N-carbazolyl)-1,1'-biphenyl, >99.9%, OSM), Ir(ppy)₂acac (bis(2-phenylpyridine)iridium(iii) acetylacetonate, >99.5%, OSM) and lithium fluoride (Foosung) were prepared as materials for thermal deposition.

FA_{0.9}GA_{0.1}PbBr₃ perovskite nanocrystals were synthesized at room temperature (17 - 19 °C) in normal air. A precursor solution was formed by dissolving FABr, GABr and PbBr₂ in 0.5 mL of anhydrous N,N-dimethylformamide (the molar ratio of FABr:GABr was 9:1, and FABr + GABr and PbBr₂ were 0.2 and 0.1 mmol, respectively). Next, the precursor solution was added to a crystallization-inducing solution, which was mixed with 5.0 mL of toluene, 2.00 mL of 1-butanol, 0.30 mL of oleic acid and 24.2 µL of n-decylamine and stirred vigorously for 10 minutes. Afterwards, the generated colloidal perovskite nanocrystals were sequentially centrifuged, washed and then collected in toluene.

A glass substrate patterned with indium tin oxide (ITO) corresponding to a first electrode layer was sequentially ultrasonically cleaned in acetone and 2-propanol for 15 minutes each. The glass substrate was boiled in 2-isopropanol for 5 minutes, then transferred to an ultraviolet-ozone cleaner and treated with ultraviolet-ozone for 10 minutes to remove residual organic substances. Next, Buf-HIL (buffered hole injection layer) composed of poly(3,4-ethylenedioxythiophene)/poly(styrene sulfonate) (PEDOT:PSS) and a perfluorinated ionomer was spin-coated as a first hole transport layer on the substrate in air with a thickness of 60 nm, and then annealed at 150°C for 30 minutes to perform effective self-organization for PEDOT:PSS and perfluorinated ionomer. Considering the low glass transition temperature (*T*g: ~85°C) of PET (polyethylene terephthalate) substrates used in the fabrication of flexible devices, Buf-HIL was annealed at 80 °C for 30 minutes. Thereafter, it was transferred to a glove box and spin-coated at 500 rpm for 60 seconds with the perovskite nanocrystal solution to form a perovskite light-emitting layer. Next, in order to form an insulating interlayer capable of improving charge balance, a 1,3,5-tris(bromomethyl)-2,4,6-triethylbenzene solution dissolved in toluene was spin-coated at 3,000 rpm for 60 seconds. Afterwards, it was transferred to a vacuum deposition device, and a 5 nm thick TPBi layer was deposited as one layer included in the first electron transport layer corresponding to the multi-layer structure, and a 20 nm thick ZADN layer. was deposited as another layer included in the first electron transport layer. In addition, a 20 nm thickn BCL:Li (volume ratio of 9:1) co-deposition layer was deposited as an n-type charge generation layer, a 5 nm thick MoO₃ layer was deposited as a p-type charge generation layer, and a 65 nm thick TAPC layer was deposited as a second hole transport layer. Thereafter, a 5 nm thick TCTA:Ir(ppy)₂acac (volume ratio 97:3) co-deposition layer was deposited as one layer included in the organic light-emitting layer corresponding to the multi-layer structure, and a CBP:Ir(ppy)₂acac (volume ratio of 96:4) co-deposition layer was deposited as another layer included in the organic light-emitting layer. Next, a 5 nm thick TPBi layer was deposited as one layer included in the second electron transport layer corresponding to the multi-layer structure, a 50 nm thick ZADN layer was deposited as another layer included in the second electron transport layer, and a 1 nm thick LiF (lithium fluoride) layer was deposited as an electron injection layer. Thereafter, a 100 nm thick aluminum layer was deposited as the second electrode, thereby manufacturing a tandem light-emitting device. Meanwhile, the device was encapsulated before the experiment.

### Example 2

A tandem light-emitting device was manufactured in the same manner as in Example 1, except that a 25 nm thick TPBi layer was deposited as a first electron transport layer corresponding to the single-layer structure and a 55 nm thick TPBi layer was deposited as a second electron transport layer corresponding to the single-layer structure.

### Example 3

A tandem light-emitting device was manufactured in the same manner as in Example 1, except that a 25 nm thick TPBi layer was deposited as a first electron transport layer corresponding to the single-layer structure.

### Example 4

A tandem light-emitting device was manufactured in the same manner as in Example 1, except that a 55 nm thick TPBi layer was deposited as a second electron transport layer corresponding to the single-layer structure.

### Example 5

A tandem light-emitting device was manufactured in the same manner as in Example 1, except that a 90 nm thick TAPC layer was deposited as a second hole transport layer and a 30 nm thick ZADN layer was deposited as another layer included in the second electron transport layer.

### Example 6

A tandem light-emitting device was manufactured in the same manner as in Example 1, except that a 40 nm thick TAPC layer was deposited as a second hole transport layer and a 70 nm thick ZADN layer was deposited as another layer included in the second electron transport layer.

### Example 7

A tandem light-emitting device was manufactured in the same manner as in Example 1, except that a 30 nm thick TAPC layer was deposited as a second hole transport layer and a 30 nm thick ZADN layer was deposited as another layer included in the second electron transport layer.

### Example 8

A tandem light-emitting device was manufactured in the same manner as in Example 1, except that a 90 nm thick TAPC layer was deposited as a second hole transport layer and a 70 nm thick ZADN layer was deposited as another layer included in the second electron transport layer.

### Example 9

A tandem light-emitting device was manufactured in the same manner as in Example 1, except that a 95 nm thick TAPC layer was deposited as a second hole transport layer and a 55 nm thick ZADN layer was deposited as another layer included in the second electron transport layer.

### Example 10

A tandem light-emitting device was manufactured in the same manner as in Example 1, except that a 5 nm thick ZADN layer was deposited as another layer included in the first electron transport layer.

### Example 11

A tandem light-emitting device was manufactured in the same manner as in Example 1, except that a 10 nm thick ZADN layer was deposited as another layer included in the first electron transport layer.

### Example 12

A tandem light-emitting device was manufactured in the same manner as in Example 1, except that a 15 nm thick ZADN layer was deposited as another layer included in the first electron transport layer.

### Example 13

A tandem light-emitting device was manufactured in the same manner as in Example 1, except that a 40 nm thick ZADN layer was deposited as another layer included in the first electron transport layer.

### <Comparative Example>

### Comparative Example 1

A perovskite light-emitting device was manufactured in the same manner as in Example 1, except that the n-type charge generation layer, the p-type charge generation layer, the second hole transport layer, the organic light-emitting layer and the second electron transport layer were not deposited.

### Comparative Example 2

An organic light-emitting device was manufactured in the same manner as in Example 1, except that the first hole transport layer, the perovskite light-emitting layer, the insulating intermediate layer, the first electron transport layer and the n-type charge generation layer were not deposited.

### <Experimental example>

### Experimental Example 1: Optical simulation

Optical simulations were calculated by using a multi-layer thin-film OLED optical simulation method based on the classical dipole model and an optical simulation software package (J-OSTD, JooAm) developed based on this method.

The input parameters of the simulation included the refractive index of each layer, the photoluminescence quantum yield (PLQY) of the light-emitting layer, the photoluminescence spectrum of the light-emitting layer, the emitting dipole orientations of the light-emitting layer, and the experimental emission-zone distribution of the light-emitting layer. The refractive indices of the organic light-emitting layers were obtained by optically fitting variable-angle spectroscopic ellipsometry (VASE) data, which were measured by using a variable-angle spectroscopic ellipsometer (J.A. Woollam M-2000) in the angular range of 50° to 70°. Photon recycling of the perovskite light-emitting layer was not considered because the perovskite light-emitting layer was very thin (30 nm).

The emission-zone of each unit was determined by comparing the experimentally measured angle-dependent electroluminescence intensity with the optical simulation results. As a result, the emission-zone of the perovskite light-emitting unit and the organic light-emitting unit were 30 nm (the edge of the perovskite light-emitting layer) and 5 nm (the center of the organic light-emitting layer), respectively (FIG. 10). The PLQYs for the films of Ir(ppy)₂acac and perovskite nanocrystals were measured to be 86% and 77%, respectively. In addition, the emitting dipole directions of Ir(ppy)₂acac and perovskite nanocrystals were confirmed to be 74.0% and 66.7% (isotropic), respectively, through angle-dependent photoluminescence intensity analysis. For PLQY measurements, the perovskite light-emitting layer and the organic light-emitting layer were prepared on untreated quartz substrates through spin coating and vacuum deposition, respectively. For the optical simulation of the tandem light-emitting device, the perovskite light-emitting layer and the organic light-emitting layer were inserted into the light-emitting device model. All simulations were performed by assuming perfect charge balance in both the perovskite light-emitting unit and the organic light-emitting unit, which means that the number of electrically generated excitons is the same in both units. The simulated electroluminescence spectrum and full width at half maximum (FWHM) of the tandem light-emitting device are the simulated electroluminescence spectra at the forward viewing angle (0°), which is simulated at the forward viewing angle because the forward viewing angle best represents the spectrum of the tandem light-emitting device. The optical simulation itself takes into account the Purcell effect, and thus, the external quantum efficiency (EQE) calculated from the optical simulation can be expressed as EQEₛᵢₘ= ∫PLQY_{eff}(λ)× ηₒᵤₜ(λ)*d*λ, wherein PLQY_{eff}(*λ*) is the effective PLQY determined by the Purcell effect and *η*ₒᵤₜ(*λ*) is the outcoupling efficiency at a given wavelength *λ*.

Optical simulations were performed on the examples and comparative examples by using the above-described method, and the results are expressed in FIGS. 1f, 3f, 3i, 4l, 7, 9a to 9c, 9e, 9g to 9i, 10b, 11, 12 and 13c.

Specifically, the optical simulations of the tandem light-emitting device (valley-centre tandem light-emitting device) of Example 1 are shown in FIG. 1f, FIG. 3i and FIG. 10b.

In addition, the optical simulations of the tandem light-emitting device of Example 1 and the tandem light-emitting device of Example 2 (unbalanced tandem light-emitting device 1) are shown in FIG. 3f.

In addition, the optical simulations of the tandem light-emitting device of Example 1, the tandem light-emitting device of Example 5 (valley 1 tandem light-emitting device), the tandem light-emitting device of Example 6 (valley 2 tandem light-emitting device), the tandem light-emitting device of Example 7 (off-valley 1 tandem light-emitting device), the tandem light-emitting device of Example 8 (off-valley 2 tandem light-emitting device),and the tandem light-emitting device of Example 9 (thick tandem light-emitting device) are shown in FIG. 7.

In addition, the optical simulations of the tandem light-emitting devices of Example 1 (valley-centre) and Example 9 (thick) are shown in FIGS. 9a to 9c, 9e, 9g to 9i and 11.

In addition, the optical simulations of the tandem light-emitting devices of Example 1 (valley-centre), Example 7 (off-valley 1) and Example 9 (thick) are shown in FIG. 12.

In addition, the optical simulations of the tandem light-emitting devices of Examples 1 and 10 to 13 are shown in FIG. 13.

### Experimental Example 2: Image of light-emitting device in operation

The results of operating the tandem light-emitting device of Example 1 were photographed and shown in FIG. 1d. The results of operating the tandem light-emitting device of Example 1 by applying to a large-area flexible display device were photographed and shown in FIG. 2i.

### Experimental Example 3: Measurements of electroluminescence spectrum and full width at half maximum

The electroluminescence spectrum of the light-emitting device was measured by using a Keithley 236 source measure unit and a Minolta CS 2000 spectroradiometer, and the full width at half maximum was used to obtain the full width at half maximum.

The electroluminescence spectra were measured and the full width at half maximums were obtained for the light-emitting devices of Comparative Examples 1, 2, and Example 1 using the above-described methods, and the results are shown in FIGS. 1a to 1c and FIG. 2d.

In addition, the electroluminescence spectra of the light-emitting devices of Examples 1 and 2 were measured by using the above-described method, and the results are shown in FIGS. 3e, 3g, and 3i.

In addition, the electroluminescence spectra of the light-emitting devices of Examples 1 to 4 were measured by using the above-described method, and the results are shown in FIG. 4k and FIG. 5.

In addition, the electroluminescence spectra of the light-emitting devices of Examples 1, 5 to 8 were measured by using the above-described method, and the results are shown in FIGS. 8d and 8e.

In addition, the electroluminescence spectra were measured and the full width at half maximum was obtained for the light-emitting devices of Examples 1 and 9 by using the above-described method, and the results are shown in FIG. 9f.

In addition, the electroluminescence spectrum of the light-emitting device of Example 1 was measured by using the above-described method, and the results are shown in FIG. 10b.

In addition, the electroluminescence spectra of the light-emitting devices of Examples 1 and 9 were measured by using the above-described method, and the results are shown in FIGS. 11a and 11b, respectively.

In addition, the electroluminescence spectra of the light-emitting devices of Examples 1, 10 to 13 were measured by using the above-described method, and the results are shown in FIG. 14e. By using this, the full width at half maximum was obtained, and the results are shown in FIG. 13b.

In addition, the electroluminescence spectrum was measured and the full width at half maximum was obtained for the light-emitting device of Example 1, and the results are shown in FIG. 15b.

### Experimental Example 4: Measurements of current density-voltage-luminance (J-V-L)

The current density-voltage-luminance of the light-emitting device was measured by using a Keithley 236 source measure unit and a Minolta CS 2000 spectroradiometer. Meanwhile, the voltage-current efficiency was also measured.

The current density-voltage-luminance of the light-emitting devices of Comparative Example 1, Comparative Example 2 and Example 1 were measured by using the above-described method, and the results are shown in FIGS. 2a and 2b.

In addition, the current density-voltage-luminance of the light-emitting devices of Examples 1 and 2 were measured by using the above-described method, and the results are shown in FIGS. 3b and 3c. In this case, the bottom unit of FIG. 3b represents a perovskite light-emitting unit, and the top unit represents an organic light-emitting unit.

In addition, the current density-voltage-luminance of the light-emitting devices of Examples 1 to 4 were measured by using the above-described method, and the results are shown in FIGS. 4e to 4i. In this case, the bottom unit of FIGS. 4e to 4i represents a perovskite light-emitting unit, and the top unit represents an organic light-emitting unit.

In addition, the current density-voltage-luminance was measured for the light-emitting devices of Examples 1, 5 to 8 by using the above-described method, and the results are shown in FIGS. 8a and 8c.

In addition, the current density-voltage-luminance and voltage-current efficiency were measured for the light-emitting devices of Examples 1, 10 to 13 by using the above-described method, and the results are shown in FIGS. 14a, 14b, and 14d.

### Experimental Example 5: Measurements of external quantum efficiency (EQE)

The external quantum efficiency of the light-emitting devices was measured by using a Keithley 236 source measure unit and a Minolta CS 2000 spectroradiometer.

The external quantum efficiency of the light-emitting device of Example 1 was measured by using the above-described method and compared with a conventional light-emitting device, and the results are shown in FIG. 2e.

In addition, the external quantum efficiency was measured for the light-emitting devices of Comparative Example 1, Comparative Example 2, and Example 1 by using the above-described method, and the results are shown in FIG. 2c.

In addition, the external quantum efficiency was measured for the light-emitting devices of Examples 1 and 2 by using the above-described method, and the results are shown in FIGS. 3d and 3f.

In addition, the external quantum efficiency was measured for the light-emitting devices of Examples 1 to 4 by using the above-described method, and the results are shown in FIGS. 4j and 4l.

In addition, the external quantum efficiency was measured for the light-emitting devices of Examples 1, 5 to 8 by using the above-described method, and the results are shown in FIG. 8b.

In addition, the external quantum efficiency was measured for the light-emitting devices of Examples 1 and 9 by using the above-described method, and the results are shown in FIGS. 9d and 9e.

In addition, the external quantum efficiency was measured for the light-emitting devices of Examples 1, 10 to 13 by using the above-described method, and the results are shown in FIGS. 13c and 14c.

### Experimental Example 6: Measurements of transient electroluminescence and time-resolved spectrum

Transient electroluminescence and time-resolved spectra were measured by using a system consisting of a streak camera (C10627, Hamamatsu Photonics), a delay generator (DG645, Stanford Research Systems) and a function generator (Agilent 33250A). The voltage pulses used for the measurements were 5 ms in width, 20 Hz in repetition frequency, and were set to the turn-on voltage of each device (e.g., 3.0 V for organic and perovskite light-emitting devices, and 5.9 V for tandem light-emitting devices, respectively).

Transient electroluminescence, streak camera images and time-resolved spectra were measured for the light-emitting devices of Comparative Examples 1, 2, and Example 1 by using the above-described methods, and the results are shown in FIGS. 2f to 2h.

In addition, the transient electroluminescence intensity of the light-emitting devices of Examples 1 to 4 was measured by using the above-described method, and the results are shown in FIG. 6.

### Experimental Example 7: Measurements of operating lifetime of light-emitting device

The operating lifetime of the light-emitting device was determined by measuring the luminance and electroluminescence spectra over time under an electrical stress condition of *L₀* = 100 cd/m² by using a Keithley 236 source measure unit and a Minolta CS 2000 spectroradiometer.

The luminance and electroluminescence spectra over time were measured for the light-emitting devices of Example 1 and Comparative Example 1 by using the above-described method, and the results are shown in FIG. 15.

### Experimental Example 8: Various experimental values

Meanwhile, the current efficiency, power efficiency and WPE (Wall Plug Efficiency) of the light-emitting devices of Example 1, Comparative Example 1 and Comparative Example 2 were obtained by using the experimental methods used in Experimental Examples 3 to 5, and the results are shown in Table 1.

**[Table 1]**

| | Current efficiency (cd/A) | Power efficiency (lm/W) | WPE (W/W, %) | EQE (%) | Luminance (cd/m²) | Full width at half maximum (nm) |
|---|---|---|---|---|---|---|
| Comparative Example 1 | 66.2 | 61.2 | 10.8 | 14.6 | 8,015 | 21.9 |
| Comparative Example 2 | 76.5 | 77.6 | 14.8 | 20.3 | 109,072 | 64.5 |
| Example 1 | 151.8 | 80.8 | 14.5 | 37.0 | 28,579 | 27.3 |

In addition, the external quantum efficiency and the peak and full width at half maximum of the electroluminescence spectrum predicted or measured by simulation in the experimental examples described above were organized, and the CIE color coordinates and response time were obtained and shown in Table 2.

**[Table 2]**

| | EQE (measurement) (%) | EQQ (simulation) (%) | EQE (measurement)/ EQQ (simulation) (%) | Electroluminescence spectrum peak (nm) | Full width at half maximum (nm) | CIE (x,y) | Response time (µs) |
|---|---|---|---|---|---|---|---|
| Example 1 | 37.0 | 37.1 | 99.7 | 529 | 27.3 | (0.22 3, 0.720 ) | 48 |
| Example 2 | 25.8 | 35.2 | 73.3 | 527 | 31.8 | (0.23 3, 0.705 ) | 169 |
| Example 3 | 26.4 | 36.4 | 72.5 | 528 | 28.4 | (0.23 7, 0.710 ) | 129 |
| Example 4 | 21.0 | 35.8 | 58.7 | 526 | 42.2 | (0.24 8, 0.677 ) | 85 |
| Example 5 | 13.9 | 33.7 | 41.2 | 524 | 40.0 | (0.24 9, 0.674 ) | |
| Example 6 | 15.3 | 35.0 | 43.7 | 526 | 35.1 | (0.22 4, 0.703 ) | |
| Example 7 | 10.9 | 14.7 | 74.1 | 520 | 58.5 | (0.29 8, 0.640 ) | |
| Example 8 | 25.8 | 46.7 | 55.2 | 533 | 57.0 | (0.34 8, 0.623 ) | |
| Example 9 | 29.4 | 50.8 | 57.9 | 531 | 50.5 | (0.32 8, 0.641 ) | |
| Example 10 | 14.7 | 25.1 | 32.3 | 516 | 41.0 | (0.26 8, 0.659 ) | |
| Example 11 | 20.6 | 28.9 | 80.9 | 525 | 33.5 | (0.23 6, 0.697 ) | |
| Example 12 | 26.7 | 33.0 | 71.3 | 526 | 30.0 | (0.23 0, 0.708 ) | |
| Example 13 | 15.9 | 49.2 | 58.6 | 531 | 48.1 | (0.30 6, 0.654 ) | |

When it is described by referring to FIG. 2, FIG. 15, Table 1 and Table 2, the tandem light-emitting device of Example 1 showed an external quantum efficiency of 30% or more, which was superior to the efficiency of the conventional perovskite light-emitting device, and a full width at half maximum of 30 nm or less, which resulted in high color purity. In contrast, the perovskite light-emitting device of Comparative Example 1 had a very low external quantum efficiency, and the organic light-emitting device of Comparative Example 2 had a large full width at half maximum, which resulted in significantly reduced color purity. In addition, Example 1 had a turn-on reaction time close to that of Comparative Example 1, and a turn-off reaction time close to that of Comparative Example 2, and the turn-off reaction time and the turn-on reaction time were much shorter than those of Comparative Example 1 and Comparative Example 2, respectively. Furthermore, the operating lifetime of Example 1 was LT₅₀ of 113 hours (LT₅₀ = 5,596 hours under an electrical stress state of *L*₀ = 1,000 cd/m²), which was superior to that of Comparative Example 1, which had an LT₅₀ of only 1 hour and 48 minutes.

When it is described by referring to FIGS. 3 to 6 and Tables 1 and 2, Example 1, unlike Examples 2 to 4, had both the first electron transport layer and the second electron transport layer as multi-layer structures, thereby showing almost perfect charge balance, and exhibited high external quantum efficiency and full width at half maximum as predicted by the optical simulation. In contrast, Examples 2 to 4 had at least one electron transport layer as a multi-layer structure, which caused charge imbalance, and as a result, the external quantum efficiency did not exceed 30%, unlike what was predicted by the optical simulation, and the full width at half maximum did not reach 28 nm or less, resulting in lower luminescence efficiency and color purity than in Example 1. Moreover, Examples 2 to 4 showed a larger shift of the electroluminescence spectrum peak than in Example 1, and the turn-on response time was longer than in Example 1, resulting in lower performance.

When it is described by referring to FIGS. 7 and 8, Tables 1 and 2, Example 1, in which the thicknesses of the first and second electron transport layers were appropriately controlled while satisfying Relationship Formula 2 above and/or Relationship Formula 3 above, was superior to Examples 5 to 8 in external quantum efficiency, luminance and full width at half maximum, and was close to Lambertian reflection. However, Examples 5 to 8 did not reach an external quantum efficiency of 30% or more, contrary to the predicted values, and the full width at half maximum did not reach 30 nm or less.

When it is described by referring to FIGS. 9 to 11, Tables 1 and 2, Example 9 was predicted to achieve higher external quantum efficiency than Example 1 in the optical simulation, but a charge imbalance occurred, resulting in an external quantum efficiency of less than 30% and a full width at half maximum exceeding 30 nm, resulting in insufficient color purity, and being far from Lambertian reflection, resulting in overall inferior performance to Example 1.

When it is described by referring to FIG. 12, Example 1 showed the most intense luminescence at a viewing angle of 0° since it was most consistent with the entire electroluminescence spectrum at a viewing angle of 0°, and thus, when used in a display device, it may achieve strong color purity and luminance at a viewing angle of 0°, which is the most important. However, Examples 7 and 9 had a more inconsistent overall electroluminescence spectrum at a viewing angle of 0° than Example 1, and thus, it may be disadvantageous in color purity and luminance compared to Example 1 at the most important angle of 0°.

When it is described by referring to FIGS. 13 to 14, Tables 1 and 2, Example 1 having an appropriate first electron transport layer thickness was superior in current efficiency, full width at half maximum and external quantum efficiency compared to Examples 10 to 13 which did not have such an appropriate first electron transport layer thickness. In particular, Example 13 was predicted to achieve an external quantum efficiency of 49.2% in the optical simulation, but the actual measured value was measured to be very low at less than 20% due to charge imbalance.

Finally, considering the experimental examples described above, it was confirmed that Example 1, which corresponds to a valley-centre tandem light-emitting device with an appropriate thickness controlled while satisfying the relationship formulas described above, achieved high color purity by showing a very excellent full width at half maximum compared to other comparative examples and examples, and it was also confirmed that the luminescence efficiency, such as the external quantum efficiency, was maximized.

Although the embodiments of the present invention have been described above, the spirit of the present invention is not limited to the embodiments presented in the present specification, and those skilled in the art who understand the idea of the present invention will be able to easily propose other embodiments by modifying, changing, deleting or adding components within the scope of the same spirit, but this will also be considered to fall within the spirit of the present invention.

## Claims

1. A tandem light-emitting device, comprising:
a first electrode;
a perovskite light-emitting unit disposed on the first electrode, and comprising a first hole transport layer, a perovskite light-emitting layer and a first electron transport layer;
a charge generation layer disposed on the perovskite light-emitting unit;
an organic light-emitting unit disposed on the charge generation layer, and comprising a second hole transport layer, an organic light-emitting layer and a second electron transport layer; and
a second electrode disposed on the organic light-emitting unit,
wherein by controlling thicknesses of the second hole transport layer and the second electron transport layer, a full width at half maximum (FWHM) of an emission spectrum of the entire tandem light-emitting device satisfies Relationship Formula 1 below: <Relationship Formula 1> $FWHM \left(PeLED\right) \leq FWHM \left(tandem\right) \leq FWHM \left(OLED\right)$
wherein the FWHM (OLED) is a full width at half maximum of a light-emitting device that comprises an organic light-emitting unit and does not comprise a perovskite light-emitting unit,
wherein the FWHM (tandem) is a full width at half maximum of the tandem light-emitting device, and
wherein the FWHM (PeLED) is a full width at half maximum of a light-emitting device that comprises a perovskite light-emitting unit and does not comprise an organic light-emitting unit.

2. The tandem light-emitting device of claim 1,
wherein at least one refractive index selected from the group consisting of the first hole transport layer, the first electron transport layer, the second hole transport layer, and the second electron transport layer is in the range of 1.4 to 2.2.

3. The tandem light-emitting device of claim 1, wherein the perovskite light-emitting layer comprises a crystal structure of ABX₃, A₄BX₆, AB₂X₅, A₂BX₄, A₂BX₆, A₂B⁺B³⁺X₆, A₃B₂X₉ or A'₂Aₖ₋₁BₖX₃ₖ₊₁,
wherein the A is a monovalent organic cation, a monovalent inorganic cation or a combination thereof,
wherein the B is one or more types of metal ions,
wherein the X is F⁻, Cl⁻, Br⁻, I⁻, SCN⁻, OCN⁻, SeCN⁻, HCO²⁻, CH₃COO⁻ or a combination thereof, and
wherein k is an integer between 2 and 6.

4. The tandem light-emitting device of claim 1, wherein the first electron transport layer and/or the second electron transport layer have a multi-layer structure.

5. The tandem light-emitting device of claim 4, wherein in the multi-layer structure, materials comprised in each layer are different from each other,
wherein in the first electron transport layer, a LUMO energy level of each layer increases as each layer gets closer to the perovskite light-emitting layer, and
wherein in the second electron transport layer, a LUMO energy level of each layer increases as each layer gets closer to the organic light-emitting layer.

6. The tandem light-emitting device of claim 1, wherein the charge generation layer comprises an n-type charge generation layer and/or a p-type charge generation layer.

7. The tandem light-emitting device of claim 1, wherein a thickness of the second hole transport layer and a thickness of the second electron transport layer satisfy Relationship Formula 2 below and/or Relationship Formula 3 below: <Relationship Formula 2> $a \leq x + by \leq c$
wherein in Relationship Formula 2, the x is a thickness of the second electron transport layer, and y is a thickness of the second hole transport layer,
wherein a is -89.474×n + 265.001, b is -1.053×n + 2.931, and c is -63.158×n + 243.001, wherein n is a refractive index of the second hole transport layer, <Relationship Formula 3> $d \leq x + ey \leq f$
wherein in Relationship Formula 3, the x is a thickness of the second electron transport layer, and y is a thickness of the second hole transport layer, and
wherein d is 15.789×m + 82.95, e is 1.105×m-0.903, and f is 135, wherein m is a refractive index of the second electron transport layer.

8. The tandem light-emitting device of claim 7, wherein a thickness of the second hole transport layer is 50 to 80 nm, and
wherein a thickness of the second electron transport layer is 40 to 60 nm.

9. The tandem light-emitting device of claim 7, wherein the perovskite light-emitting unit and the organic light-emitting unit satisfy Relationship Formula 4 below: <Relationship Formula 4> $0.8 \leq A / B \leq 1.2$
wherein the A is a current density of the perovskite light-emitting unit when an applied voltage to the perovskite light-emitting unit is 2.8 V, and
wherein the B is a current density of the organic light-emitting unit when an applied voltage to the organic light-emitting unit is 2.8 V.

10. The tandem light-emitting device of claim 1, wherein the organic light-emitting layer comprises a host and/or a dopant,
wherein the host contains one or more selected from the group consisting of CBP, TCTA, mCP, DCzPPy, PCPPn, PCPN, CzTP, TCPB, and CzPA, and
wherein the dopant contains one or more selected from the group consisting of a fluorescent organic material, a phosphorescent organic material, and a thermally activated delayed fluorescent organic material.

11. The tandem light-emitting device of claim 1, wherein the full width at half maximum is 30 nm or less.

12. The tandem light-emitting device of claim 1, wherein an external quantum efficiency (EQE) is 30% or more.

13. A display device, comprising the tandem light-emitting device of claim 1.

14. A method for manufacturing a tandem light-emitting device, the method comprising:
1) forming a perovskite light-emitting unit by sequentially forming a first hole transport layer, a perovskite light-emitting layer and a first electron transport layer on a first electrode;
(2) forming a charge generation layer on the first electron transport layer;
(3) forming an organic light-emitting unit by sequentially forming a second hole transport layer, an organic light-emitting layer and a second electron transport layer on the charge generation layer; and
(4) forming a second electrode on the second electron transport layer,
wherein by controlling thicknesses of the second hole transport layer and the second electron transport layer, a full width at half maximum (FWHM) of an emission spectrum of the entire tandem light-emitting device satisfies Relationship Formula 1 below: <Relationship Formula 1> $FWHM \left(PeLED\right) \leq FWHM \left(tandem\right) \leq FWHM \left(OLED\right)$
wherein the FWHM (OLED) is a full width at half maximum of a light-emitting device that comprises an organic light-emitting unit and does not comprise a perovskite light-emitting unit,
wherein the FWHM (tandem) is a full width at half maximum of the tandem light-emitting device, and
wherein the FWHM (PeLED) is a full width at half maximum of a light-emitting device that comprises a perovskite light-emitting unit and does not comprise an organic light-emitting unit.

15. The method of claim 14, wherein the first hole transport layer and the perovskite light-emitting layer are deposited through a solution process, and
wherein the first electron transport layer, the charge generation layer, the second hole transport layer, the organic light-emitting layer and the second electron transport layer are deposited through a dry process.

16. The method of claim 14, wherein the second hole transport layer and the second electron transport layer are deposited to thicknesses that satisfy Relationship Formula 2 below and/or Relationship Formula 3 below, respectively: <Relationship Formula 2> $a \leq x + by \leq c$
wherein in Relationship Formula 2, the x is a thickness of the second electron transport layer, and y is a thickness of the second hole transport layer,
wherein a is -89.474×n + 265.001, b is -1.053×n + 2.931, and c is -63.158×n + 243.001, wherein n is a refractive index of the second hole transport layer, <Relationship Formula 3> $d \leq x + ey \leq f$
wherein in Relationship Formula 3, the x is a thickness of the second electron transport layer, and y is a thickness of the second hole transport layer, and
wherein d is 15.789×m + 82.95, e is 1.105×m-0.903, and f is 135, wherein m is a refractive index of the second electron transport layer.

17. The method of claim 16, wherein a thickness of the second hole transport layer is deposited to be 50 to 80 nm, and a thickness of the second electron transport layer is deposited to be 40 to 60 nm.

18. The method of claim 14, wherein the method manufactures the tandem light-emitting device of claim 1.
